# EUROPEAN PATENT APPLICATION

(11) **EP 4 386 856 A1**
(43) Date of publication of application: **19.06.2024**
(21) Application number: 21961842.8
(22) Date of filing: 28.10.2021
(51) Int. Cl.: H01L 29/73, H01L 21/331

(54) **FIN-BIPOLAR JUNCTION TRANSISTOR AND PREPARATION METHOD THEREFOR, AND ELECTRONIC DEVICE**

(71) Applicant: Huawei Technologies Co., Ltd., Shenzhen, Guangdong 518129 (CN)
(72) Inventor: TIAN, Ziliang, Shenzhen, Guangdong 518129 (CN); WAN, Guangxing, Shenzhen, Guangdong 518129 (CN); QIU, Chengbo, Shenzhen, Guangdong 518129 (CN); WONG, Waisum, Shenzhen, Guangdong 518129 (CN)
(74) Representative: Körber, Martin Hans
(86) International application number: PCT/CN2021/127195
(87) International publication number: WO 2023/070477

(57) **Abstract**

Embodiments of this application relate to the field of semiconductor technologies, and provide a fin-bipolar junction transistor, a preparation method of the fin-bipolar junction transistor, and an electronic device, to resolve a problem of how to form a FinBJT, having a strong driving current capability, that can be mass produced and used in products. The fin-bipolar junction transistor FinBJT includes a substrate, and two collectors, a plurality of emitters, and at least one base that are disposed on the substrate. In the FinBJT, each collector includes at least one fin, each emitter includes at least one fin, and each base includes at least one fin. For example, the collector, the emitter, and the base may be formed by using a FinFET process. In the FinBJT, the plurality of emitters and the at least one base are all located between the two collectors, each collector is adjacent to one of the plurality of emitters, and the base is disposed between adjacent emitters. A layout manner of the emitter and the base is adjusted, so that an area proportion of the emitter is increased, thereby improving a driving current capacity of the FinBJT.

## Description

### TECHNICAL FIELD

This application relates to the field of semiconductor technologies, and in particular, to a fin-bipolar junction transistor, a preparation method of the fin-bipolar junction transistor, and an electronic device.

### BACKGROUND

With the development of semiconductor technologies, semiconductor components with high integration and high performance become mainstream products in the future. A fin field-effect transistor (fin field-effect transistor, FinFET) is a complementary metal oxide semiconductor transistor with high performance. A main characteristic of the FinFET is that a channel region is a fin-shaped semiconductor whose top surface and side surfaces are covered by a gate. A length of a fin along a source-drain direction is a length of a channel. A structure wrapped in the gate enhances a control capability of the gate, provides better electrical control for the channel, reduces a leakage current, and suppresses short-channel effect. In a special structure design of the FinFET, a process design rule is improved and process deviation is reduced, so that a smaller design scale can be used to implement higher performance and lower power consumption.

A bipolar junction transistor (bipolar junction transistor, BJT) is a current control component with good performance, and is widely used in integrated circuits, such as a voltage regulator circuit, and a temperature sensor, for its strong current and voltage amplification capability.

On the basis of advantages of a FinFET process, persons skilled in the art attempt to introduce the FinFET process into the BJT, to obtain a fin-bipolar junction transistor (fin-bipolar junction transistor, FinBJT) that can be mass produced and put into commercial use. However, the FinBJT proposed in the conventional technology is not widely used in products due to factors such as poor performance or incompatibility with an actual process. Therefore, how to form a FinBJT, having a strong driving current capability, that can be mass produced and used in products become a technical problem that persons skilled in the art need to continue to study.

### SUMMARY

Embodiments of this application provide a fin-bipolar junction transistor, a preparation method of the fin-bipolar junction transistor, and an electronic device, to resolve a problem of how to form a FinBJT, having a strong driving current capability, that can be mass produced and used in products.

To achieve the foregoing objectives, this application uses the following technical solutions.

A first aspect of embodiments of this application provides a fin-bipolar junction transistor FinBJT, including: a substrate, and two collectors, a plurality of emitters, and at least one base that are disposed on the substrate. According to different materials of the substrate, the substrate and the collector, the emitter, and the base that are located on the substrate may be of an integrated structure, or may not be of an integrated structure. In the FinBJT, each collector includes at least one fin (fin), each emitter includes at least one fin, and each base includes at least one fin. For example, the collector, the emitter, and the base may be formed by using a FinFET process. In the FinBJT, the two collectors are disposed in parallel, the plurality of emitters and the at least one base are all located between the two collectors, each collector is adjacent to one of the plurality of emitters, and the base is disposed between adjacent emitters.

The plurality of emitters and the at least one base are all located between the two collectors, each collector is adjacent to one of the plurality of emitters, and the base is disposed between the adjacent emitters, so that the emitter is disposed closer to the collector, the emitter has larger layout space, and an area proportion of the emitter can be increased. In addition, there are the plurality of emitters, and the at least one base. A quantity of the emitters is greater than a quantity of the bases, and the area proportion of the emitter can be increased. Therefore, in a same area, this arrangement manner of the emitter and the base provided in this example can enable the area proportion of the emitter to reach 49.1%, and increase a current driving capability of the FinBJT. In addition, when a collection capability of the collector is not saturated, increasing an area of the emitter can increase a current (beta) gain of the FinBJT. Therefore, the FinBJT provided in this example has a higher current gain and a higher amplification characteristic. With a same current driving capability and current gain, this arrangement manner of the emitter and the base provided in this example enables the FinBJT to have a smaller area and higher integration.

In a possible implementation, the plurality of emitters, the at least one base, and the two collectors are disposed in parallel; and along an extension direction of the collector, the plurality of emitters, the at least one base, and the two collectors have equal lengths. In this way, a structure is simple, a process change can be reduced, and preparation of the collector, the emitter, and the base is convenient. Further, adaptability of the FinBJT can be improved, and process variation (mismatch) of the FinBJT in different processes can be reduced.

In a possible implementation, a quantity of fins included in each emitter is greater than a quantity of fins included in each base. A quantity of fins included in the emitters is increased by increasing a quantity of emitters in the FinBJT, the area proportion of the emitter can be increased, and the current gain of the FinBJT can be increased.

In a possible implementation, each emitter includes at least three fins. In this application, the collector is adjacent to the emitter, and the base is disposed between the adjacent emitters, so that the emitter is disposed closer to the collector, and the emitter has larger layout space. Compared with that in a manner of disposing an emitter between adjacent bases, the emitter can include more fins, and the emitter can have a larger area proportion in the manner of disposing the emitter in this application.

In a possible implementation, the FinBJT further includes: a collector line, disposed on the two collectors, and connected to and in contact with the two collectors; an emitter line, disposed on the plurality of emitters, and connected to and in contact with the plurality of emitters; and a base line, disposed on the at least one base, and connected to and in contact with the at least one base.

In a possible implementation, the FinBJT further includes a shallow groove isolation structure, and the shallow groove isolation structure is disposed on the substrate; and the shallow groove isolation structure wraps a first part, of the two collectors, the plurality of emitters, and the at least one base respectively, that is close to the substrate, and exposes a second part, of the two collectors, the plurality of emitters, and the at least one base respectively, that is away from the substrate.

In a possible implementation, the FinBJT further includes a plurality of first interconnection structures and at least one second interconnection structure that are disposed on the shallow groove isolation structure; extension directions of the plurality of first interconnection structures and the at least one second interconnection structure intersect with the extension direction of the collector; a top surface and two opposite side surfaces of the second part of each collector are in contact with at least one first interconnection structure; and each second interconnection structure is in contact with a top surface and two opposite side surfaces of the second part of each emitter and a top surface and two opposite side surfaces of the second part of each base. Each second interconnection structure is in contact with the top surface and the two opposite side surfaces of the second part of each emitter and the top surface and the two opposite side surfaces of the second part of each base, that is, an interconnection structure in contact with the emitter and base is connected as an integrated structure. After the second interconnection structure is powered on, channel inversion may be formed below the second interconnection structure, so that the channel is also used as an effective region of the emitter, thereby further increasing an effective area of the emitter.

A second aspect of embodiments of this application provides a preparation method of a fin-bipolar junction transistor FinBJT, and the method includes: forming a mask plate on a basement; and etching, a part, of the basement, that is not covered by the mask plate, to form a substrate, and two collectors, a plurality of emitters, and at least one base that are located on the substrate. For example, the collector, the emitter, and the base may be formed by using a FinFET process, so that each collector includes at least one fin, each emitter includes at least one fin, and each base includes at least one fin. The plurality of emitters and the at least one base are all located between the two collectors, each collector is adjacent to one of the plurality of emitters, and the base is disposed between adjacent emitters.

In embodiments of this application, a conventional process is used during preparation of the FinBJT. In other words, in embodiments of this application, the FinBJT can be prepared by using a conventional process, without a complex and high-cost process or a new process to be developed. Therefore, the preparation method of the FinBJT provided in embodiments of this application has low costs, and can be used for mass production of the FinBJT. Further, the FinBJT prepared in the preparation method of the FinBJT provided in embodiments of this application has a strong current driving capability, and can be widely used in various products.

In a possible implementation, the preparation method further includes: forming a shallow groove isolation structure on the substrate, where the shallow groove isolation structure wraps a first part, of the two collectors, the plurality of emitters, and the at least one base respectively, that is close to the substrate, and exposes a second part, of the two collectors, the plurality of emitters, and the at least one base respectively, that is away from the substrate.

In a possible implementation, the preparation method further includes: forming a plurality of first interconnection structures and at least one second interconnection structure on the shallow groove isolation structure, where extension directions of the plurality of first interconnection structures and the at least one second interconnection structure intersect with an extension direction of the collector; a top surface and two opposite side surfaces of the second part of each collector are in contact with at least one first interconnection structure; and each second interconnection structure is in contact with a top surface and two opposite side surfaces of the second part of each emitter and a top surface and two opposite side surfaces of the second part of each base. Each second interconnection structure is in contact with the top surface and the two opposite side surfaces of the second part of each emitter and the top surface and the two opposite side surfaces of the second part of each base, that is, an interconnection structure in contact with the emitter and base is connected as an integrated structure. After the second interconnection structure is powered on, channel inversion may be formed below the second interconnection structure, so that the channel is also used as an effective region of the emitter, thereby further increasing an effective area of the emitter.

In a possible implementation, after the plurality of first interconnection structures and the at least one second interconnection structure are formed, the preparation method further includes: forming a collector line, an emitter line, and a base line, where the collector line is connected to and in contact with the two collectors, the emitter line is connected to and in contact with the plurality of emitters, and the base line is connected to and in contact with the at least one base.

A third aspect of embodiments of this application provides a fin-bipolar junction transistor FinBJT, including: a substrate, and two collectors, at least one emitter, and a plurality of bases that are disposed on the substrate. According to different materials of the substrate, the substrate and the collector, the emitter, and the base that are located on the substrate may be of an integrated structure, or may not be of an integrated structure. In the FinBJT, each collector includes at least one fin, each emitter includes at least one fin, and each base includes at least one fin. For example, the collector, the emitter, and the base may be formed by using a FinFET process. In the FinBJT, the two collectors are disposed in parallel, the at least one emitter and the plurality of bases are all located between the two collectors and arranged along an extension direction of the collector; and along the extension direction of the collector, the emitter is disposed between adjacent bases, and the base is located on an outermost side.

The at least one emitter and the plurality of bases are all located between the two collectors, and the at least one emitter and the plurality of bases are arranged along the extension direction (a first direction) of the collector. In this arrangement manner, a spacing between the emitter and the base is located in the extension direction of the collector, and is no longer located in a second direction. In the second direction, in addition to a spacing between fins, only a spacing between the emitter (or the base) and the collector is included, and the spacing between the emitter and the base is not included. Therefore, integration of the FinBJT can be improved and an area of an integrated circuit can be reduced in a manner in which a size in the first direction is not increased and a size in the second direction is reduced. In addition, in this example, the arrangement manner in which the at least one emitter and the plurality of bases are arranged along the extension direction of the collector can increase a quantity of fins in the emitter, and reduce a length of the fin in the emitter. This is equivalent to increasing a width of the emitter, and reducing a length of the emitter; and is equivalent to changing a shape of the emitter from a rectangle to a square. When a sum of a length and a width is fixed, an area of the square is greater than an area of the rectangle (for example, 4*4 is greater than 3*5). This can increase an area proportion of the emitter. Therefore, in a same area, this arrangement manner of the emitter and the base provided in this example can enable the area proportion of the emitter to reach 53.2%, and increase a current driving capability of the FinBJT. In addition, when a collection capability of the collector is not saturated, increasing an area of the emitter can increase a current (beta) gain of the FinBJT. Therefore, the FinBJT provided in this example has a higher current gain and a higher amplification characteristic. With a same current driving capability and current gain, this arrangement manner of the emitter and the base provided in this example enables the FinBJT to have a smaller area and higher integration.

In a possible implementation, a length of a fin in each emitter is greater than a length of a fin in each base. A length of the emitter is designed to be greater, so that the area proportion of the emitter can be increased, and the current gain of the FinBJT can be increased.

In a possible implementation, the FinBJT further includes a shallow groove isolation structure, and the shallow groove isolation structure is disposed on the substrate; and the shallow groove isolation structure wraps a first part, of the two collectors, the at least one emitter, and the plurality of bases respectively, that is close to the substrate, and exposes a second part, of the two collectors, the at least one emitter, and the plurality of bases respectively, that is away from the substrate.

In a possible implementation, the FinBJT further includes a plurality of first interconnection structures, at least one third interconnection structure, and a plurality of fourth interconnection structures that are disposed on the shallow groove isolation structure; extension directions of the plurality of first interconnection structures, the at least one third interconnection structure, and the plurality of fourth interconnection structures intersect with the extension direction of the collector; a top surface and two opposite side surfaces of the second part of each collector are in contact with at least one first interconnection structure; a top surface and two opposite side surfaces of the second part of each emitter are in contact with the at least one third interconnection structure; and a top surface and two opposite side surfaces of the second part of each base are in contact with at least one fourth interconnection structure. The first interconnection structure, the third interconnection structure, and the fourth interconnection structure are disposed in the FinBJT; and the first interconnection structure, the third interconnection structure, and the fourth interconnection structure can be formed synchronously with a gate strip in a FinFET, so that a FinBJT process is compatible with a FinFET process.

In a possible implementation, a top surface and two opposite side surfaces of the second part of each base are in contact with one fourth interconnection structure. When space between adjacent collectors is fixed, each base is in contact with only one fourth interconnection structure, so as to minimize an area of the base. Remaining space can be reserved to dispose the emitter, and this increases an area proportion of the emitter.

In a possible implementation, the FinBJT further includes: a collector line, disposed on the two collectors, and connected to and in contact with the two collectors; an emitter line, disposed on the at least one emitter, and connected to and in contact with the at least one emitter; and a base line, disposed on the plurality of bases, and connected to and in contact with the plurality of bases.

A fourth aspect of embodiments of this application provides a preparation method of a fin-bipolar junction transistor FinBJT, and the method includes: forming a mask plate on a basement; and etching, a part, of the basement, that is not covered by the mask plate, to form a substrate, and two collectors, at least one emitter, and a plurality of bases that are located on the substrate. For example, the collector, the emitter, and the base may be formed by using a FinFET process, so that each collector includes at least one fin, each emitter includes at least one fin, and each base includes at least one fin. The at least one emitter and the plurality of bases are all located between the two collectors and arranged along an extension direction of the collector; and along the extension direction of the collector, the emitter is disposed between adjacent bases, and the base is located on an outermost side.

In embodiments of this application, a conventional process is used during preparation of the FinBJT. In other words, in embodiments of this application, the FinBJT can be prepared by using a conventional process, without a complex and high-cost process or a new process to be developed. Therefore, the preparation method of the FinBJT provided in embodiments of this application has low costs, and can be used for mass production of the FinBJT. Further, the FinBJT prepared in the preparation method of the FinBJT provided in embodiments of this application has a strong current driving capability, and can be widely used in various products.

In a possible implementation, the preparation method further includes: forming a shallow groove isolation structure on the substrate, where the shallow groove isolation structure wraps a first part, of the two collectors, the at least one emitter, and the plurality of bases respectively, that is close to the substrate, and exposes a second part, of the two collectors, the at least one emitter, and the plurality of bases respectively, that is away from the substrate.

In a possible implementation, the preparation method further includes: forming a plurality of first interconnection structures, at least one third interconnection structure, and a plurality of fourth interconnection structures on the shallow groove isolation structure, where extension directions of the plurality of first interconnection structures, the at least one third interconnection structure, and the plurality of fourth interconnection structures intersect with the extension direction of the collector; a top surface and two opposite side surfaces of the second part of each collector are in contact with at least one first interconnection structure; a top surface and two opposite side surfaces of the second part of each emitter are in contact with the at least one third interconnection structure; and a top surface and two opposite side surfaces of the second part of each base are in contact with at least one fourth interconnection structure.

In a possible implementation, after the plurality of first interconnection structures, the at least one third interconnection structure, and the plurality of fourth interconnection structures are formed, the preparation method further includes: forming a collector line, an emitter line, and a base line, where the collector line is connected to and in contact with the two collectors, the emitter line is connected to and in contact with the at least one emitter, and the base line is connected to and in contact with the plurality of bases.

A fifth aspect of embodiments of this application provides a fin-bipolar junction transistor FinBJT, including: a substrate, and two collectors, a plurality of emitters, and at least one base that are disposed on the substrate. According to different materials of the substrate, the substrate and the collector, the emitter, and the base that are located on the substrate may be of an integrated structure, or may not be of an integrated structure. In the FinBJT, each collector includes at least one fin, each emitter includes at least one fin, and each base includes at least one fin. For example, the collector, the emitter, and the base may be formed by using a FinFET process. In the FinBJT, the two collectors are disposed in parallel, the plurality of emitters and the at least one base are all located between the two collectors and arranged along an extension direction of the collector; and along the extension direction of the collector, the base is disposed between adjacent emitters, and the emitter is located on an outermost side.

The plurality of emitters and the at least one base are all located between the two collectors, and the plurality of emitters and the at least one base are arranged along the extension direction (a first direction) of the collector. In this arrangement manner, a spacing between the emitter and the base is located in the extension direction of the collector, and is no longer located in a second direction. In the second direction, in addition to a spacing between fins, only a spacing between the emitter (or the base) and the collector is included, and the spacing between the emitter and the base is not included. Therefore, integration of the FinBJT can be improved and an area of an integrated circuit can be reduced in a manner in which a size in the first direction is not increased and a size in the second direction is reduced. In addition, in this example, the arrangement manner in which the plurality of emitters and the at least one base are arranged along the extension direction of the collector can increase a quantity of fins in the emitter, and reduce a length of the fin in the emitter. This is equivalent to increasing a width of the emitter, and reducing a length of the emitter; and is equivalent to changing a shape of the emitter from a rectangle to a square. When a sum of a length and a width is fixed, an area of the square is greater than an area of the rectangle (for example, 4*4 is greater than 3*5). This can increase an area proportion of the emitter. Therefore, in a same area, this arrangement manner of the emitter and the base provided in this example can enable the area proportion of the emitter to reach 54.6%, and increase a current driving capability of the FinBJT. In addition, when a collection capability of the collector is not saturated, increasing an area of the emitter can increase a current (beta) gain of the FinBJT. Therefore, the FinBJT provided in this example has a higher current gain and a higher amplification characteristic. With a same current driving capability and current gain, this arrangement manner of the emitter and the base provided in this example enables the FinBJT to have a smaller area and higher integration.

In a possible implementation, the FinBJT further includes a shallow groove isolation structure, and the shallow groove isolation structure is disposed on the substrate; and the shallow groove isolation structure wraps a first part, of the two collectors, the plurality of emitters, and the at least one base respectively, that is close to the substrate, and exposes a second part, of the two collectors, the plurality of emitters, and the at least one base respectively, that is away from the substrate.

In a possible implementation, a length of a fin in each emitter is greater than a length of a fin in each base. A length of the emitter is designed to be greater, so that the area proportion of the emitter can be increased, and the current gain of the FinBJT can be increased.

In a possible implementation, the FinBJT further includes a plurality of first interconnection structures, a plurality of third interconnection structures, and at least one fourth interconnection structure that are disposed on the shallow groove isolation structure; extension directions of the plurality of first interconnection structures, the plurality of third interconnection structures, and the at least one fourth interconnection structure intersect with the extension direction of the collector; a top surface and two opposite side surfaces of the second part of each collector are in contact with at least one first interconnection structure; a top surface and two opposite side surfaces of the second part of each emitter are in contact with at least one third interconnection structure; and a top surface and two opposite side surfaces of the second part of each base are in contact with the at least one fourth interconnection structure.

In a possible implementation, a top surface and two opposite side surfaces of the second part of each base are in contact with one fourth interconnection structure.

In a possible implementation, the FinBJT further includes: a collector line, disposed on the two collectors, and connected to and in contact with the two collectors; an emitter line, disposed on the plurality of emitters, and connected to and in contact with the plurality of emitters; and a base line, disposed on the at least one base, and connected to and in contact with the at least one base.

A sixth aspect of embodiments of this application provides a preparation method of a fin-bipolar junction transistor FinBJT, and the method includes: forming a mask plate on a basement; and etching, a part, of the basement, that is not covered by the mask plate, to form a substrate, and two collectors, a plurality of emitters, and at least one base that are located on the substrate. For example, the collector, the emitter, and the base may be formed by using a FinFET process, so that each collector includes at least one fin, each emitter includes at least one fin, and each base includes at least one fin. The plurality of emitters and the at least one base are all located between the two collectors and arranged along an extension direction of the collector; and along the extension direction of the collector, the base is disposed between adjacent emitters, and the emitter is located on an outermost side.

In embodiments of this application, a conventional process is used during preparation of the FinBJT. In other words, in embodiments of this application, the FinBJT can be prepared by using a conventional process, without a complex and high-cost process or a new process to be developed. Therefore, the preparation method of the FinBJT provided in embodiments of this application has low costs, and can be used for mass production of the FinBJT. Further, the FinBJT prepared in the preparation method of the FinBJT provided in embodiments of this application has a strong current driving capability.

In a possible implementation, the preparation method further includes: forming a shallow groove isolation structure on the substrate, where the shallow groove isolation structure wraps a first part, of the two collectors, the plurality of emitters, and the at least one base respectively, that is close to the substrate, and exposes a second part, of the two collectors, the plurality of emitters, and the at least one base respectively, that is away from the substrate.

In a possible implementation, the preparation method further includes: forming a plurality of first interconnection structures, a plurality of third interconnection structures, and at least one fourth interconnection structure on the shallow groove isolation structure, where extension directions of the plurality of first interconnection structures, the plurality of third interconnection structures, and the at least one fourth interconnection structure intersect with the extension direction of the collector; a top surface and two opposite side surfaces of the second part of each collector are in contact with at least one first interconnection structure; a top surface and two opposite side surfaces of the second part of each emitter are in contact with at least one third interconnection structure; and a top surface and two opposite side surfaces of the second part of each base are in contact with the at least one fourth interconnection structure.

In a possible implementation, after the plurality of first interconnection structures, the plurality of third interconnection structures, and the at least one fourth interconnection structure are formed, the preparation method further includes: forming a collector line, an emitter line, and a base line, where the collector line is connected to and in contact with the two collectors, the emitter line is connected to and in contact with the plurality of emitters, and the base line is connected to and in contact with the at least one base.

A seventh aspect of embodiments of this application provides an electronic device, including an integrated circuit and a printed circuit board. The integrated circuit is electrically connected to the printed circuit board; and the integrated circuit includes the fin-bipolar junction transistor FinBJT according to any one of the first aspect, any one of the third aspect, or any one of the fifth aspect.

The electronic device provided in embodiments of this application includes the FinBJT, and beneficial effect of the electronic device is the same as beneficial effect of the FinBJT. Details are not described herein again.

In a possible implementation, the integrated circuit further includes a fin field-effect transistor FinFET, and a gate in the FinFET and a first interconnection structure in the FinBJT are disposed at a same layer.

The FinBJT and the FinFET are integrated on a same substrate, so that the integrated circuit can have features of both the FinBJT and the FinFET, thereby improving performance of the integrated circuit.

### BRIEF DESCRIPTION OF DRAWINGS

FIG. 1 is a schematic diagram of a voltage regulator circuit according to an embodiment of this application;
FIG. 2A is a diagram of an arrangement manner of electrodes in a FinBJT according to an embodiment of this application;
FIG. 2B is a sectional view along an A1-A2 direction in FIG. 2A;
FIG. 3A is a diagram of another arrangement manner of electrodes in a FinBJT according to an embodiment of this application;
FIG. 3B is a sectional view along a B1-B2 direction in FIG. 3A;
FIG. 4 is a flowchart of a preparation method of a FinBJT according to an embodiment of this application;
FIG. 5A is a schematic diagram of a structure of a basement according to an embodiment of this application;
FIG. 5B is a schematic diagram of a part of a preparation process of a mask plate according to an embodiment of this application;
FIG. 5C is a schematic diagram of a part of a preparation process of a mask plate according to an embodiment of this application;
FIG. 6A is a schematic diagram of a preparation process of electrodes according to an embodiment of this application;
FIG. 6B is a diagram of still another arrangement manner of electrodes in a FinBJT according to an embodiment of this application;
FIG. 7 to FIG. 13A each are a schematic diagram of a part of a preparation process of a FinBJT according to an embodiment of this application;
FIG. 13B is a sectional view along a C1-C2 direction in FIG. 13A;
FIG. 13C is a sectional view along a D1-D2 direction in FIG. 13A;
FIG. 13D is a schematic diagram of a structure of a FinBJT according to an embodiment of this application;
FIG. 14 is a schematic diagram of a structure of a mask plate according to an embodiment of this application;
FIG. 15 is a diagram of still another arrangement manner of electrodes in a FinBJT according to an embodiment of this application;
FIG. 16A is a diagram of still another arrangement manner of electrodes in a FinBJT according to an embodiment of this application;
FIG. 16B is a diagram of still another arrangement manner of electrodes in a FinBJT according to an embodiment of this application;
FIG. 17 is a schematic diagram of a structure of a shallow groove isolation structure in a FinBJT according to an embodiment of this application;
FIG. 18A is a schematic diagram of an arrangement manner of a first interconnection structure, a third interconnection structure, and a fourth interconnection structure according to an embodiment of this application;
FIG. 18B is a sectional view along an E1-E2 direction in FIG. 18A;
FIG. 18C is a sectional view along an F1-F2 direction in FIG. 18A;
FIG. 19A is a schematic diagram of an arrangement manner of an emitter line, a base line, and a collector line according to an embodiment of this application;
FIG. 19B is a sectional view along a G1-G2 direction in FIG. 19A;
FIG. 19C is a sectional view along an H1-H2 direction in FIG. 19A;
FIG. 20 is a schematic diagram of a structure of another mask plate according to an embodiment of this application;
FIG. 21 is a diagram of still another arrangement manner of electrodes in a FinBJT according to an embodiment of this application;
FIG. 22A is a diagram of still another arrangement manner of electrodes in a FinBJT according to an embodiment of this application;
FIG. 22B is a diagram of still another arrangement manner of electrodes in a FinBJT according to an embodiment of this application;
FIG. 23A is a schematic diagram of another arrangement manner of a first interconnection structure, a third interconnection structure, and a fourth interconnection structure according to an embodiment of this application;
FIG. 23B is a sectional view along an I1-I2 direction in FIG. 23A; and
FIG. 24 is a schematic diagram of an integrated structure of a FinBJT and a FinFET according to an embodiment of this application.

### Reference numerals:

10-substrate; 100-basement; 20-shallow groove isolation structure; 31-first interconnection structure; 311-first interconnection structure line; 32-second interconnection structure; 321-second interconnection structure line; 33-third interconnection structure; 34-fourth interconnection structure; 40-flattening layer; 41-first via hole; E-emitter; EL-emitter line; E-1-first part of the emitter; E-2-second part of the emitter; B-base; BL-base line; B-1-first part of the base; B-2-second part of the base; C-collector; CL-collector line; C-1-first part of the collector; C-2-second part of the collector; S-source; D-drain; G-gate; NW-N-type well region; PW-P-type well region; and DNW-deep N-type well region.

### DESCRIPTION OF EMBODIMENTS

The following describes technical solutions in embodiments of this application with reference to accompanying drawings in embodiments of this application. It is clear that the described embodiments are merely some rather than all of embodiments of this application.

Terms such as "first" and "second" mentioned below in embodiments of this application are merely used for ease of description, and shall not be understood as an indication or implication of relative importance or implicit indication of a quantity of indicated technical features. Therefore, features defined with "first", "second", and the like may explicitly or implicitly include one or more such features. In the descriptions of this application, unless otherwise stated, "a plurality of" means two or more than two.

In embodiments of this application, "up", "down", "left", and "right" are not limited to definitions relative to directions in which components are schematically placed in accompanying drawings. It should be understood that these directional terms may be relative concepts used for relative description and clarification, and may change correspondingly based on a change of a direction in which a component in an accompanying drawing is placed.

In embodiments of this application, unless otherwise specified in the context, in the entire specification and claims, the term "include" is interpreted as "open and inclusive", that is, "include, but not limited to". In the descriptions of the specification, terms such as "an embodiment", "some embodiments", "example embodiments", "examples", or "some examples" are intended to indicate that specific features, structures, materials, or features related to embodiments or examples are included in at least one embodiment or example of the present disclosure. The foregoing schematic representations of the terms do not necessarily refer to a same embodiment or example. Further, the particular feature, structure, material, or characteristic may be included in any one or more embodiments or examples in any appropriate manner.

When some embodiments are described, expressions of "coupling" and "connection" and their extensions may be used. For example, when some embodiments are described, the term "connection" may be used to indicate that two or more components are in direct physical contact or electrical contact with each other. For another example, when some embodiments are described, the term "coupling" may be used to indicate that two or more components are in direct physical contact or electrical contact. However, the term "coupling" may also indicate that two or more components do not directly contact each other, but still collaborate or interact with each other. Embodiments disclosed herein are not necessarily limited to content of this specification.

The term "and/or" in embodiments of this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

In embodiments of this application, an example implementation is described with reference to a sectional view and/or a plane diagram and/or an equivalent circuit diagram that are/is used as idealized example accompanying drawings. In the accompanying drawings, for clarity, thicknesses of layers and regions are increased. Thus, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. For example, an etching region shown as a rectangle typically has a bending characteristic. Therefore, the regions shown in the accompanying drawings are essentially examples, and their shapes are not intended to show actual shapes of regions of a device, and are not intended to limit a scope of the example implementations.

Embodiments of this application provide an electronic device. The electronic device is, for example, a consumer electronic product, a home electronic product, a vehicle-mounted electronic product, or a financial terminal product. The consumer electronic product is, for example, a mobile phone (mobile phone), a tablet (pad), a notebook computer, an e-reader, a personal computer (personal computer, PC), a personal digital assistant (personal digital assistant, PDA), a desktop display, an intelligent wearable product (for example, a smart watch or a smart band), a virtual reality (virtual reality, VR) terminal device, an augmented reality (augmented reality, AR) terminal device, or an uncrewed aerial vehicle. The home electronic product is, for example, an intelligent lock, a television, a remote control, a refrigerator, and a small household charging appliance (such as a soy milk maker and a robot vacuum). The vehicle-mounted electronic product is, for example, a vehicle-mounted navigator and a vehicle-mounted DVD. The financial terminal product is, for example, an ATM and a terminal for self-help services. A specific form of the electronic device is not specially limited in embodiments of this application.

The electronic device may include elements such as an integrated circuit and a printed circuit board (printed circuit board, PCB). The integrated circuit is electrically connected to the printed circuit board, to implement signal interworking.

Based on this, embodiments of this application provide an integrated circuit. The integrated circuit may be used in the foregoing electronic device.

The integrated circuit may be a circuit configured to implement a single function, or the integrated circuit may include a plurality of circuits configured to implement different functions. This is not limited in embodiments of this application. After being packaged, the integrated circuit may be used in the electronic device in a form of a chip. Certainly, the electronic device may alternatively be directly used in the electronic device without being packaged.

Generally, a voltage regulator circuit and a temperature sensor are key parts of a large-scale integrated circuit, and a key circuit part of each of the voltage regulator circuit and the temperature sensor includes a bipolar junction transistor (bipolar junction transistor, BJT).

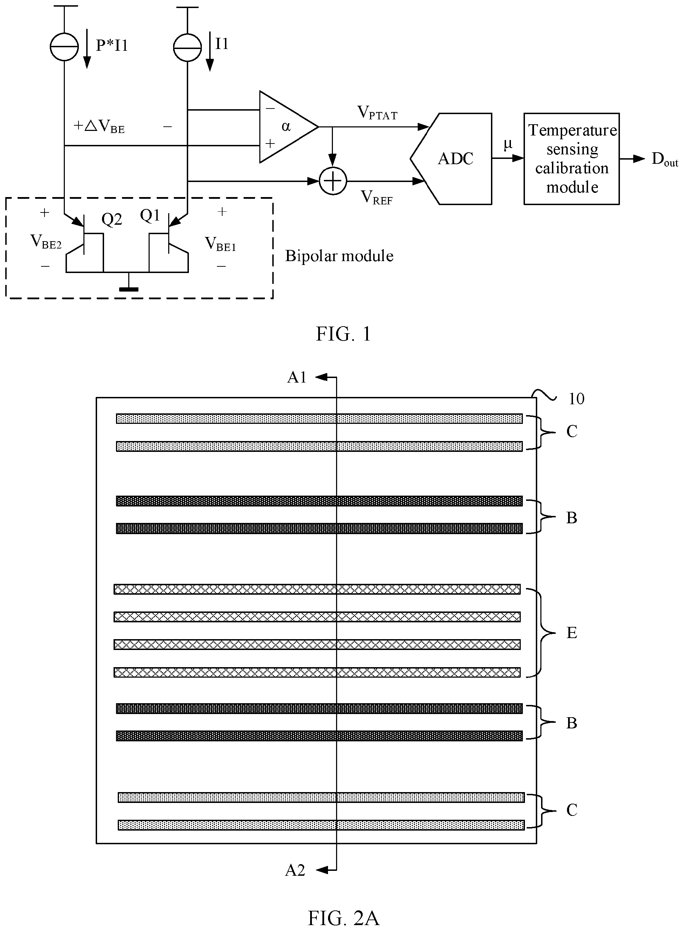

For example, as shown in FIG. 1, an integrated circuit includes a voltage regulator circuit, and the voltage regulator circuit is to generate a regulated voltage output that is unrelated to a temperature and that is used by another circuit module. The voltage regulator circuit includes a bipolar module (bipolar core), an amplifier α, a digital-to-analog converter ADC, and a temperature sensing calibration module (scaling). A core part of the voltage regulator circuit is the bipolar module, and the bipolar module includes two groups of BJTs. In FIG. 1, Q1 and Q2 are used to represent the two groups of BJTs. Q1 includes one BJT, an input current of the BJT is I1, and a base voltage is V_{BE1}. Q2 includes p BJTs connected in parallel, an input current of the p BJTs is p*I1, and a base voltage is V_{BE2}. △VBE is a difference between V_{BE1} and V_{BE2}, △V_{BE} is positively correlated with the temperature, and △V_{BE} passes through the amplifier α to obtain a voltage V_{PTAT}. V_{BE1} is negatively correlated with the temperature. After V_{PTAT} and V_{BE1} are weighted, a temperature drift characteristic of V_{BE1} is canceled within a specific range, to obtain an output voltage V_{REF} with approximately zero temperature drift. The digital-to-analog converter ADC senses a difference signal between V_{PTAT} and V_{REF}, and outputs a numerical signal µ. The numerical signal µ passes through the temperature sensing calibration module, and then the temperature sensing calibration module outputs Dₒᵤₜ. This generates the regulated voltage output that is unrelated to the temperature and that is used by the another circuit module.

Therefore, performance of the BJT has a direct influence on performance of the integrated circuit like the voltage regulator circuit.

Because of a special structure design, a fin field-effect transistor (fin field-effect transistor, FinFET) brings obvious effect. Therefore, a smaller design scale may be used to implement higher performance and lower power consumption. In addition, if the FinFET and the BJT are integrated into a same integrated circuit, integration of the integrated circuit can be improved, and performance of the integrated circuit can be improved.

Therefore, with the introduction of a FinFET process, a process of a BJT structure also transits from a planar process to a stereoscopic process, and various fin-bipolar junction transistor (fin-bipolar junction transistor, FinBJT) structures are proposed and studied. However, currently, a FinBJT structure proposed by persons skilled in the art is not put into commercial use due to poor performance or incompatibility with an actual process.

Based on this, embodiments of this application provide a FinBJT. As shown in FIG. 2A, the FinBJT includes a substrate 10, two collectors (collectors, C), at least one emitter (emitter, E), and a plurality of bases (bases, B). The collectors C, the emitter E, and the bases B are all disposed on the substrate 10.

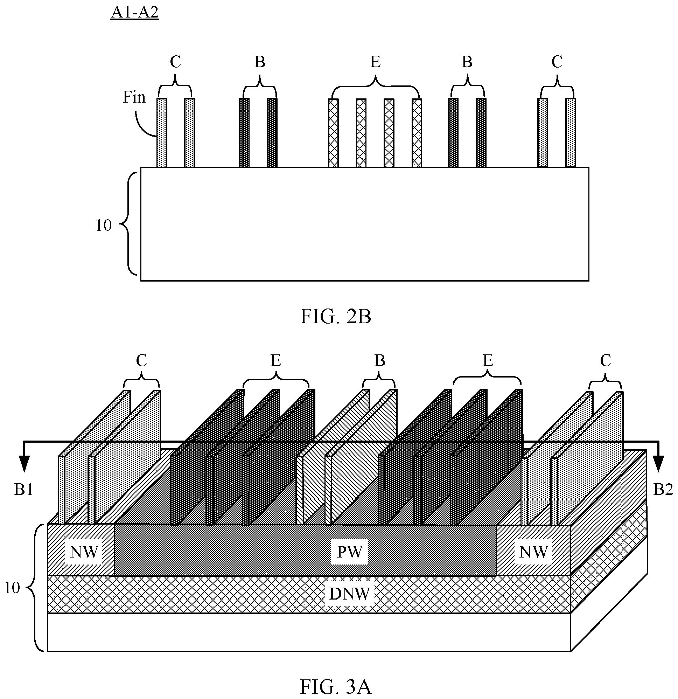

In FIG. 2A and FIG. 2B (a sectional view along an A1-A2 direction in FIG. 2A), that the FinBJT includes two collectors C, one emitter E, and two bases B is used as an example for illustration. Each collector C includes two fins, each emitter E includes four fins, and each base B includes two fins.

As shown in FIG. 2A, the two collectors C are disposed in parallel, and both the emitter E and the bases B are all located between the two collectors C. The two collectors C are respectively adjacent to the bases B, and the emitter E is disposed between the adjacent bases B. The collectors C, the emitter E, and the bases B are all of a strip structure, and fins included in the collectors C, the emitter E, and the bases B are also of a strip structure.

According to the FinBJT provided in embodiments of this application, a square BJT of a conventional plane is converted into a strip BJT formed by a fin (fin) structure, and a fin used as a source and a fin used as a drain in the FinFET are also strip-shaped. Therefore, the FinBJT provided in embodiments of this application may be prepared by using a same process as the FinFET.

Compared with a conventional BJT structure, the FinBJT structure shown in FIG. 2B can reduce a size of the BJT and reduce power consumption of the BJT. In addition, the FinBJT structure shown in FIG. 2B may be widely used in 16 nm, 7 nm, and 5 nm process nodes. Therefore, the FinBJT structure shown in FIG. 2B is widely put into commercial use for its good performance and compatibility with an existing process.

However, in the FinBJT shown in FIG. 2A and FIG. 2B, an area of the emitter E in the FinBJT is not large enough, and consequently, a driving current capability of the FinBJT is poor.

Based on this, to further improve an area proportion of the emitter E in the FinBJT, and improve the driving current capability of the FinBJT, embodiments of this application further provide a FinBJT. The following uses several examples to describe the FinBJT provided in embodiments of this application.

### Example 1

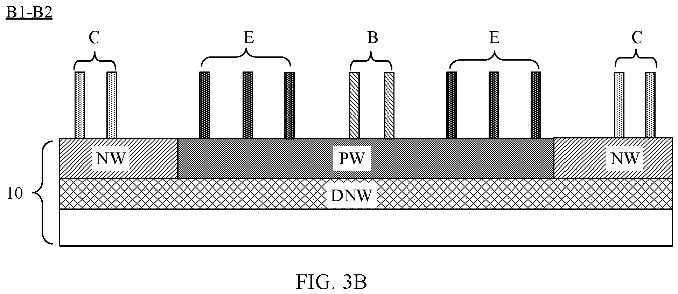

A FinBJT is provided. As shown in FIG. 3A and FIG. 3B (a sectional view along a B 1-B2 direction in FIG. 3A), the FinBJT mainly includes a substrate 10, two collectors C, a plurality of emitters E, and at least one base B. The two collectors C, the plurality of emitters E, and the at least one base B are all disposed on the substrate 10.

In FIG. 3A, that the FinBJT includes two collectors C, two emitters E, and one base B is used as an example for illustration. Each collector C includes two fins, each emitter E includes two fins, and each base B includes two fins. Structures of the collector C, the emitter E, and the base B in the FinBJT are described below in detail. Details are not described herein.

The two collectors C are disposed in parallel, the plurality of emitters E and the at least one base B are all located between the two collectors C, each collector C is adjacent to one of the plurality of emitters E, and the base B is disposed between adjacent emitters E.

The substrate 10 includes N-type wells (Nwells, NWs) and a P-type well (Pwell, PW). An NPN-type FinBJT is used as an example. Two sides of the PW are NWs, and a lower part of both the PW and the NW is a deep N-type well (deep Nwell, DNW). The P-doped plus (P+) base B and the N-doped plus (N+) emitters E are disposed above the PW, and the N-doped plus (N+) collectors C are disposed above the NWs.

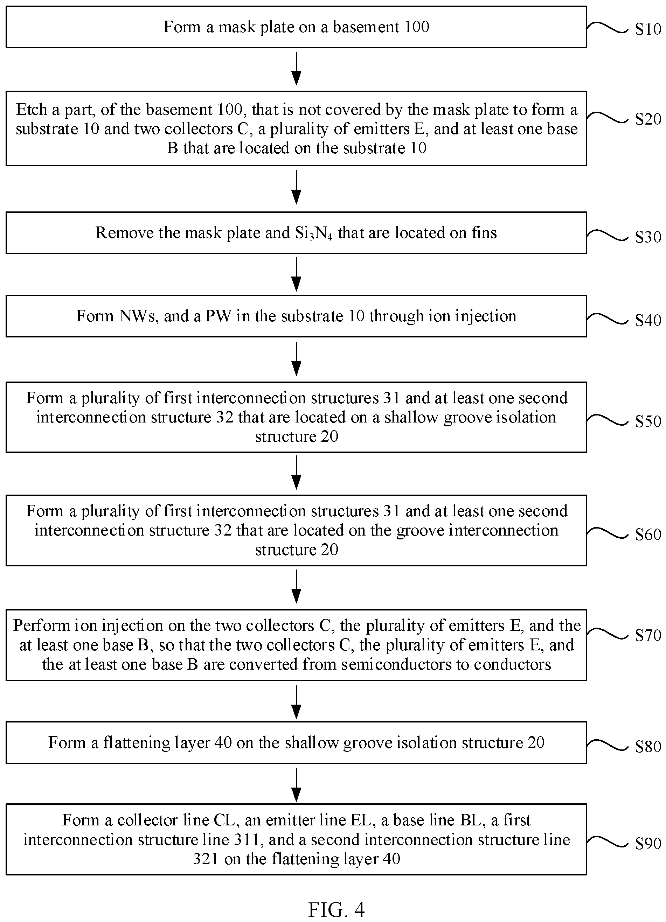

For example, a preparation method of the FinBJT is provided. As shown in FIG. 4, the preparation method of the FinBJT includes the following steps.

S 10: Form a mask plate on a basement 100.

Herein, the basement 100 is configured to subsequently form the substrate 10 and the collector C, the emitter E, and the base B that are located on the substrate 10.

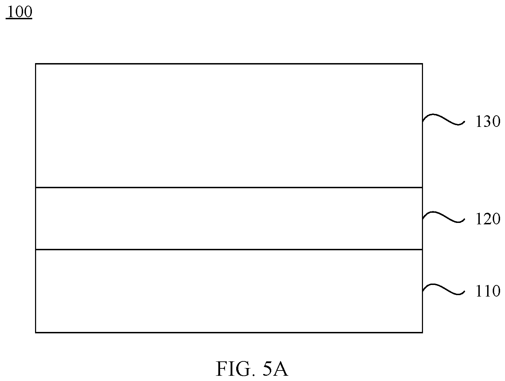

In some embodiments, as shown in FIG. 5A, the basement 100 is a semiconductor on insulator (semiconductor on insulator, SOI) basement.

For example, the SOI basement includes a semiconductor layer 110, a buried insulation layer 120 located on the semiconductor layer 110, and a silicon (Si) layer 130 located on the buried insulation layer 120.

The buried insulation layer 120 may include an oxide, a nitride, or an oxygen nitride. The buried insulation layer 120 may include one layer or a plurality of layers having the same or different components.

The silicon layer 130 is formed on the buried insulation layer 120, and the silicon layer 130 is configured to form, by using a subsequent photoetching process, a fin used as an electrode. The buried insulation layer 120 is an etching barrier layer. That is, a subsequently formed fin is located above the buried insulation layer 120.

In other words, the semiconductor layer 110 and the buried insulation layer 120 are used as the substrate 10 in the FinBJT in this embodiment of this application, and the silicon layer 130 is patterned to form the collector C, the emitter E, and the base B.

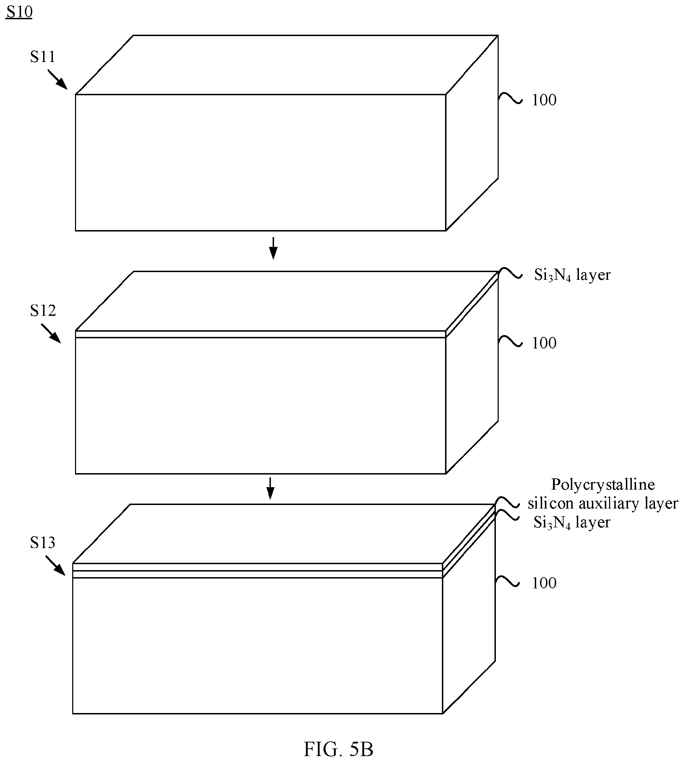

In some other embodiments, as shown in FIG. 5B, the basement 100 is a bulk silicon basement.

For ease of description, the following describes the FinBJT and the preparation method of the FinBJT provided in this embodiment of this application by using an example in which basement 100 is the bulk silicon basement.

For example, step S10 includes the following steps.

S11: As shown in FIG. 5B, provide the basement 100.

S12: As shown in FIG. 5B, deposit a silicon nitride (Si₃N₄) layer on the basement 100 as a barrier layer.

The Si₃N₄ layer is configured to protect the basement 100, so as to avoid damage to the basement 100 in a subsequent process of forming the mask plate. Certainly, step S12 may be performed or may not be performed according to a requirement.

S13: As shown in FIG. 5B, deposit a polycrystalline silicon auxiliary layer on the Si₃N₄ layer.

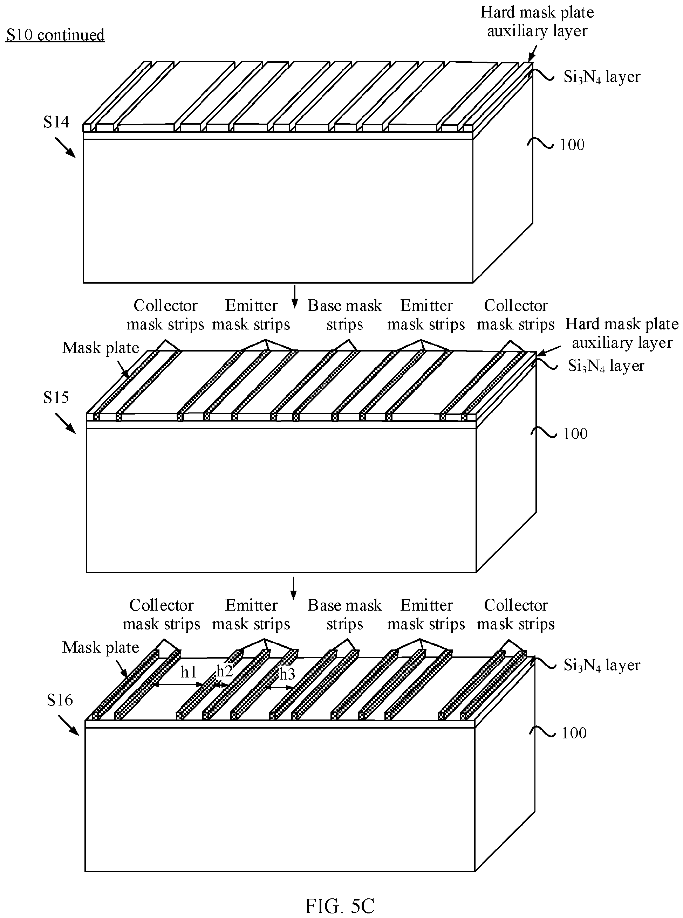

S14: As shown in FIG. 5C, form a hard mask plate auxiliary layer by performing photoetching and etching on the polycrystalline silicon auxiliary layer.

The hard mask plate auxiliary layer corresponds to a to-be-etched region in the basement 100, and an opening region (namely, a part removed through etching in the polycrystalline silicon auxiliary layer) of the hard mask plate auxiliary layer corresponds to a region of a mask strip to be formed subsequently, that is, corresponds to a region in which the collector C, emitter E, and base B are to be formed subsequently.

Therefore, the polycrystalline silicon auxiliary layer is patterned in an arrangement manner of the collector C, emitter E, and base B to be formed. If the arrangement manners of the collector C, the emitter E, and the base B are different, patterns of the hard mask plate auxiliary layers formed after patterning are also different.

S15: As shown in FIG. 5C, deposit a silicon oxide (SiO₂) layer, pattern the SiO₂ layer, and reserve SiO₂ at an opening of the hard mask plate auxiliary layer as the mask strip.

The SiO₂ layer may be patterned by using a photoetching and etching process. The SiO₂ layer may alternatively be patterned by using a grinding process. Certainly, another process may be used. This is not limited in embodiments of this application.

The mask strips are divided into a collector mask strip, an emitter mask strip, and a base mask strip based on arrangement of the collector C, emitter E, and base B to be formed.

In this example, the mask plate includes two groups of collector mask strips, a plurality of groups of emitter mask strips, and at least one group of base mask strips. The plurality of groups of emitter mask strips and the at least one group of base mask strips are located between the two groups of collector mask strips; the two groups of collector mask strips each are adjacent to one group of emitter mask strips, and one group of base mask strips is disposed between two adjacent groups of emitter mask strips.

In some embodiments, as shown in FIG. 5C, the mask plate includes two groups of collector mask strips, two groups of emitter mask strips, and one group of base mask strips. The two groups of emitter mask strips are located between the two groups of collector mask strips, and the base mask strips are located between the two groups of emitter mask strips.

In other words, along a direction perpendicular to an extension direction of the mask strip, an arrangement sequence of the mask strips is a group of collector mask strips, a group of emitter mask strips, a group of base mask strips, a group of emitter mask strips, and a group of collector mask strips.

As shown in FIG. 5C, according to an arrangement manner of the mask strips in this example, each group of collector mask strips may include two collector mask strips, and the two groups of collector mask strips include four collector mask strips in total. Each group of emitter mask strips includes three emitter mask strips, and the two groups of emitter mask strips include six emitter mask strips in total. Each group of base mask strips includes two base mask strips, and the two groups of base mask strips include four base mask strips in total.

In some embodiments, as shown in FIG. 5C, a spacing between mask strips of different types is greater than a spacing between mask strips of a same type.

In other words, a spacing h1 between adjacent collector mask strip and emitter mask strip is greater than a spacing h2 between adjacent emitter mask strips (or adjacent collector mask strips, or adjacent base mask strips). Similarly, a spacing h3 between adjacent emitter mask strip and base mask strip is greater than the spacing h2 between the adjacent emitter mask strips.

In some embodiments, as shown in FIG. 5C, the pacing h2 between the adjacent emitter mask strips, the spacing between the adjacent collector mask strips, and the spacing between the adjacent base mask strips are equal.

In some embodiments, as shown in FIG. 5C, the collector mask strip, the emitter mask strip, and the base mask strip are parallel to each other.

It may be understood that a part, of the basement 100, that is covered by the mask strips corresponds to fins in the collector C, the emitter E, and the base B that are subsequently formed. Therefore, descriptions of structures of and a location relationship between the mask strips herein are those of corresponding structures of and a location relationship between the fins in the collector C, the emitter E, and the base B that are subsequently formed. Details are not described herein, and are described in detail in subsequent steps of preparing the collector C, the emitter E, and the base B.

S 16: As shown in FIG. 5C, remove the hard mask plate auxiliary layer to form the mask plate located on the basement 100.

The mask plate herein may be understood as a hard mask plate commonly referred to in this field.

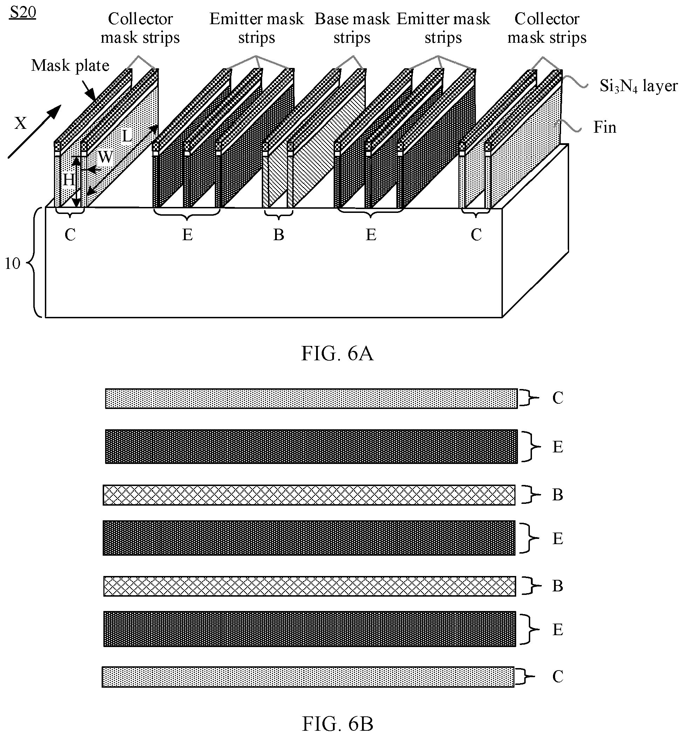

S20: As shown in FIG. 6A, etch a part, of the basement 100, that is not covered by the mask plate to form a substrate 10 and two collectors C, a plurality of emitters E, and at least one base B that are located on the substrate 10.

It may be understood that, as shown in FIG. 6A, when the mask plate is formed, if step S12 is performed, that is, when the Si₃N₄ layer is formed between the basement 100 and the mask plate, when the basement 100 is etched, the Si₃N₄ layer is also etched, and Si₃N₄ also exists between finally formed electrode and mask strip.

As shown in FIG. 6A, after the part, of the basement 100, that is not covered by the mask plate is etched, a plurality of fins are formed. A fin under the collector mask strip is used as the collector C, a fin under the emitter mask strip is used as the emitter E, and a fin under the base mask strip is used as the base B. In FIG. 6A, fins used as different electrodes are distinguished by using different fillings.

That is, a fin corresponding to one group of collector mask strips is used as one collector C in the FinBJT, a fin corresponding to one group of emitter mask strips is used as one emitter E in the FinBJT, and a fin corresponding to a group of base mask strips is used as one base B in the FinBJT.

In this case, fins corresponding to the two groups of collector mask strips are used as the two collectors C in the FinBJT, fins corresponding to the plurality of groups of emitter mask strips are used as the plurality of emitters E in the FinBJT, and fins corresponding to the at least one group of base mask strips are used as the at least one base B in the FinBJT.

Different quantities of collectors C, emitters E, and bases B that are arranged in different manners may be prepared by adjusting the structures of the mask strips in the mask plate.

The mask plate in this example (refer to the foregoing descriptions of the mask plate in FIG. 5C) is used as an example, and the two collectors C, the plurality of emitters E, and the at least one base B may be prepared.

Along the direction perpendicular to the extension direction (a first direction X) of the collector C, an arrangement manner of the two collectors C, the plurality of emitters E, and the at least one base B is as follows: The plurality of emitters E and the at least one base B are all located between the two collectors C, each collector C is adjacent to one of the plurality of emitters E, and the base B is disposed between adjacent emitters E.

In some embodiments, as shown in FIG. 6A, the FinBJT includes two collectors C, two emitters E, and one base B. The two emitters E are disposed between the two collectors C, and the base B is disposed between the two emitters E.

For example, in a same process node as that in FIG. 2A and FIG. 2B (for example, a total of 12 fins may be made in a same area), in an arrangement manner shown in FIG. 2A and FIG. 2B, the emitter E can include only four fins. In this example, as shown in FIG. 6A, each group of emitters E includes three fins, and the two groups of emitters E may include six fins in total. In the arrangement manner in this example, a quantity of fins included in the emitters E is greater than those in the arrangement manner shown in FIG. 2A. This can increase an area proportion of the emitter E in the FinBJT, and improve a driving current capability of the FinBJT.

In some other embodiments, as shown in FIG. 6B, the FinBJT includes two collectors C, three emitters E, and two bases B. The three emitters E are disposed between the two collectors C, and in the three emitters E, a base B is disposed between every two emitters E.

Arrangement manners of the collector C, the emitter E, and the base B in FIG. 6A and FIG. 6B are merely examples, and are not limited.

In some embodiments, as shown in FIG. 6A and FIG. 6B, the two collectors C, the plurality of emitters E, and the at least one base B are disposed in parallel. Along the extension direction (the first direction X) of the collector C, the two collectors C, the plurality of emitters E, and the at least one base B have an equal length.

That is, the plurality of fins forming the collector C, the emitter E, and the base B are disposed in parallel and have an equal length L (size in a fin extension direction).

In this way, a structure is simple, a process change can be reduced, and preparation of the collector C, the emitter E, and the base B is convenient. Further, adaptability of the FinBJT can be improved, and process variation (mismatch) of the FinBJT in different processes can be reduced.

In some embodiments, as shown in FIG. 6A, the plurality of fins forming the collector C, the emitter E, and the base B have an equal width W (size in a direction parallel to the substrate 10 and perpendicular to the fin extension direction). In this way, preparation of the fin is convenient, and a preparation process can be simplified.

In some embodiments, as shown in FIG. 6A, the plurality of fins forming the collector C, the emitter E, and the base B have an equal height H (size in a direction perpendicular to the substrate 10). In this way, preparation of the fin is convenient, and the preparation process can be simplified.

In some embodiments, in a plurality of fins included in each emitter E, first spacings between adjacent fins are equal. In a plurality of fins included in each base B, second spacings between adjacent fins are equal. In a plurality of fins included in each collector C, third spacings between adjacent fins are equal. In this way, preparation of the fin is convenient, and the preparation process can be simplified.

In some embodiments, the first spacing, the second spacing, and the third spacing are equal, and are equal to the spacing h2 between the adjacent emitter mask strips. In this way, preparation of the fin is convenient, and the preparation process can be simplified.

In some embodiments, a spacing (equal to the spacing h1 between the adjacent collector mask strip and emitter mask strip) between the adjacent collector C and emitter E is greater than the first spacing. A spacing (equal to the spacing h3 between the adjacent emitter mask strip and base mask strip) between the adjacent emitter E and base B is greater than the first spacing.

This can prevent performance of the FinBJT from being affected due to interference generated between the collector C and the adjacent emitter E and interference generated between the emitter E and the base B.

In some embodiments, an area proportion of the plurality of emitters E in the FinBJT is greater than an area proportion of the at least one base B.

For example, as shown in FIG. 6A, an area proportion of each emitter E is greater than an area proportion of each base B. Alternatively, it is understood that a quantity of fins included in each emitter E is greater than a quantity of fins included in each base B.

The quantity of fins included in each emitter E is greater than the quantity of fins included in each base B. This can increase the area proportion of the emitter E.

In some embodiments, each emitter E includes at least three fins.

In this application, the collector C is adjacent to the emitter E, and the base B is disposed between the adjacent emitters E, so that the emitter E is disposed closer to the collector C, and the emitter E has larger layout space. Compared with that in the manner of disposing the emitter E between the adjacent bases B shown in FIG. 2A, the emitter E can include more fins, and the emitter E can have a larger area proportion in the manner of disposing the emitter E in this application.

In some embodiments, as shown in FIG. 6A, each emitter E in the FinBJT includes an equal quantity of fins. Each collector C includes an equal quantity of fins. This can simplify process difficulty, and a design is convenient.

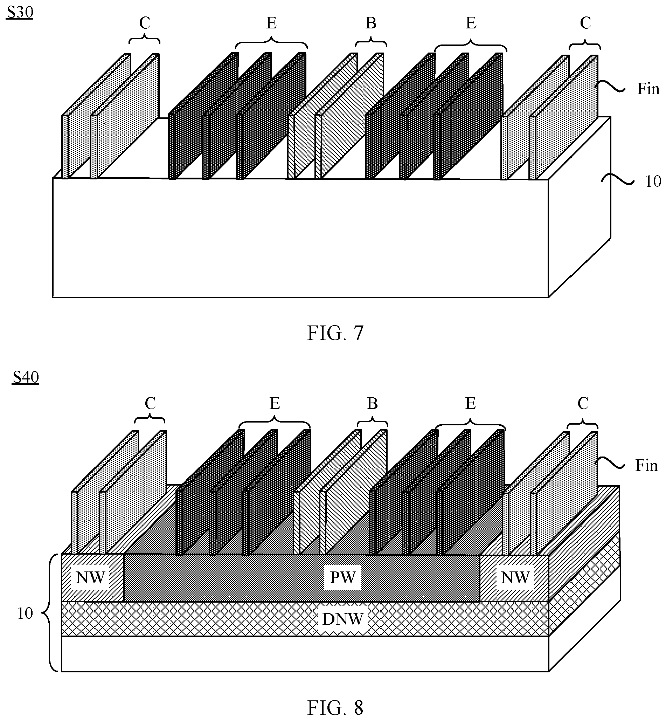

S30: As shown in FIG. 7, remove the mask plate and the Si₃N₄ that are located on the fins.

S40: As shown in FIG. 8, form a deep well region, NWs, and a PW in the substrate 10 through ion injection.

A manner of forming the NW and the PW is not limited in embodiments of this application. For example, the NW and the PW may be formed through two times of large-angle ion injection. In the conventional technology, processes that can be used to form the NW and the PW are applicable to this example. The deep well region may be formed before the NW and the PW.

In FIG. 8, an NPN-type FinBJT is used as an example for illustration, and the deep well region is a deep N-type well (Deep Nwell, DNW). If the FinBJT is a PNP-type FinBJT, the NW and PW are exchanged, and the deep well region is a deep P-type well.

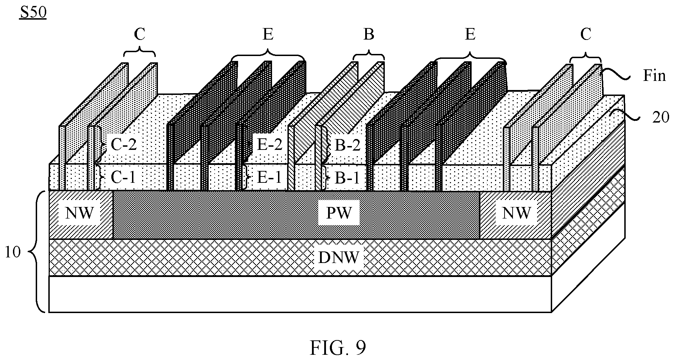

S50: As shown in FIG. 9, form a shallow groove isolation structure (for example, an STI) 20 located on the substrate 10.

In this example, a material of the shallow groove isolation structure may be, for example, SiO₂.

A manner of forming the shallow groove isolation structure may be as follows: For example, first, deposit SiO₂ by using a high density plasma chemical vapor deposition (high density plasma chemical vapor deposition, HDPCVD) process; then flatten SiO₂ by using a chemical mechanical polishing (chemical mechanical polishing, CMP) process, so that a surface of SiO₂ is flush with a top surface of the fin; and finally, perform back-etching, where a height of the shallow groove isolation structure 20 may be controlled by controlling time of back-etching, so as to control a height of a part, of the fin, that is exposed to the shallow groove isolation structure 20.

It may be understood that the fin is formed on the substrate 10, and after the shallow groove isolation structure 20 is formed on the substrate 10 on which the fin is formed, the shallow groove isolation structure 20 should wrap a periphery of the fin. According to a requirement, by adjusting the height of the shallow groove isolation structure 20, a height of a part, of the fin, that is buried in the shallow groove isolation structure 20 and the height of the part, of the fin, that is exposed to the shallow groove isolation structure 20 may be controlled.

In other words, the shallow groove isolation structure 20 wraps a first part, of the two collectors C, the plurality of emitters E, and the at least one base B respectively, that is close to the substrate 10, and the shallow groove isolation structure 20 exposes a second part, of the two collectors C, the plurality of emitters E, and the at least one base B respectively, that is away from the substrate 10.

That is, as shown in FIG. 9, the shallow groove isolation structure 20 wraps a first part C-1, of each collector C, that is close to the substrate 10, and exposes a second part C-2, of each collector C, that is away from the substrate 10. Alternatively, it is understood that each collector C includes a first part C-1 buried in the shallow groove isolation structure 20 and a second part C-2 exposed to the shallow groove isolation structure 20. In other words, each fin in the collector C includes a first part buried in the shallow groove isolation structure 20 and a second part exposed to the shallow groove isolation structure 20. For ease of illustration, the first part C-1 and the second part C-2 of the collector C are marked on one fin in the collector C in FIG. 9.

The shallow groove isolation structure 20 wraps a first part E-1, of each emitter E, that is close to the substrate 10, and exposes a second part E-2, of each emitter E, that is away from the substrate 10. Alternatively, it is understood that each emitter E includes a first part E-1 buried in the shallow groove isolation structure 20 and a second part E-2 exposed to the shallow groove isolation structure 20. In other words, each fin in the emitter E includes a first part buried in the shallow groove isolation structure 20 and a second part exposed to the shallow groove isolation structure 20. For ease of illustration, the first part E-1 and the second part E-2 of the emitter E are marked on one fin in the emitter E in FIG. 9.

The shallow groove isolation structure 20 wraps a first part B-1, of each base B, that is close to the substrate 10, and exposes a second part B-2, of each base B, that is away from the substrate 10. Alternatively, it is understood that each base B includes a first part B-1 buried in the shallow groove isolation structure 20 and a second part B-2 exposed to the shallow groove isolation structure 20. In other words, each fin in the base B includes a first part buried in the shallow groove isolation structure 20 and a second part exposed to the shallow groove isolation structure 20. For ease of illustration, the first part B-1 and the second part B-2 of the base B are marked on one fin in the base B in FIG. 9.

By adjusting the height of the shallow groove isolation structure 20, a height of the second part C-2, of the collector C, that is exposed to the shallow groove isolation structure 20, a height of the second part E-2, of the emitter E, that is exposed to the shallow groove isolation structure 20, and a height of the second part B-2, of the base B, that is exposed to the shallow groove isolation structure 20 may be adjusted, to meet different requirements.

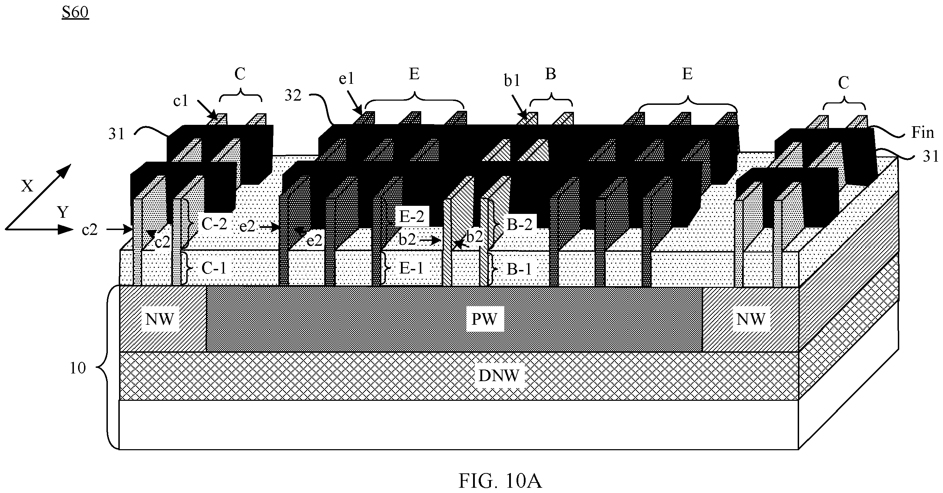

S60: As shown in FIG. 10A, form a plurality of first interconnection structures 31 and at least one second interconnection structure 32 that are located on the shallow groove isolation structure 20.

In some embodiments, for example, materials of both the first interconnection structure 31 and the second interconnection structure 32 are polycrystalline silicon.

For example, a polycrystalline silicon layer may be formed, and then the plurality of first interconnection structures 31 and the at least one second interconnection structure 32 are formed by using a photoetching and etching process.

By controlling a pattern of the photoetched mask plate, an extension direction (the first direction X) of the plurality of first interconnection structures 31 and the at least one second interconnection structure 32 may all intersect with (for example, perpendicular to) the extension direction of the collector C. For example, the plurality of first interconnection structures 31 and the at least one second interconnection structure 32 extend along a second direction Y, where the second direction Y intersects with the first direction X.

As shown in FIG. 10A, the plurality of first interconnection structures 31 are divided into two groups, and each collector C corresponds to one group of first interconnection structures 31.

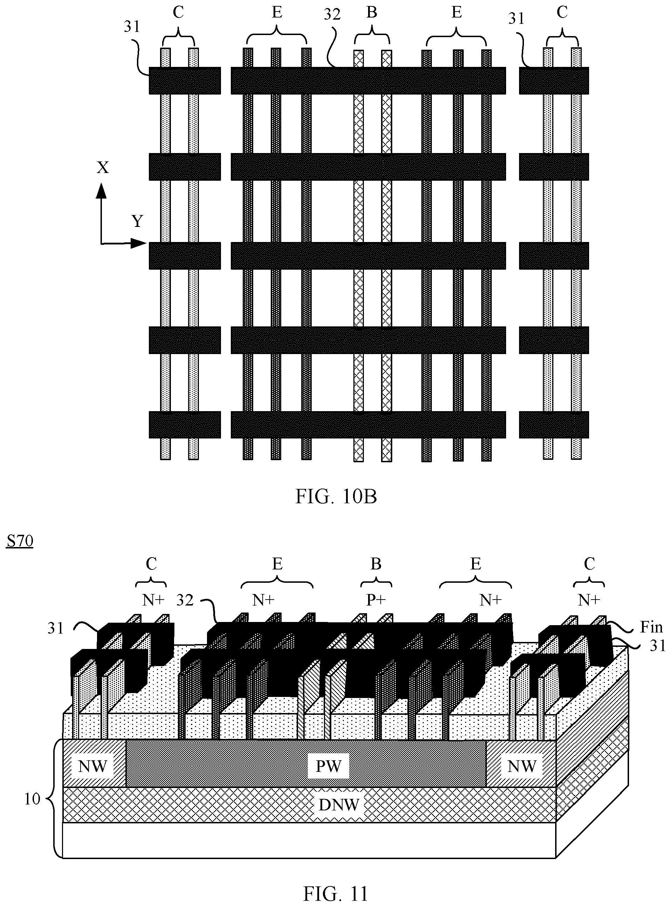

As shown in FIG. 10A and FIG. 10B, in each group of first interconnection structures 31, a quantity of first interconnection structures 31 may be appropriately disposed according to a requirement. This is not limited in embodiments of this application.

In each group of first interconnection structures 31, there may be one or more first interconnection structures 31, provided that each first interconnection structure 31 is in contact with a top surface and two opposite side surfaces of the second part C-2 of the collector C.

That is, as shown in FIG. 10A, a top surface and two opposite side surfaces of the second part C-2 of each collector C are in contact with one group of first interconnection structures 31. However, one group of first interconnection structures 31 includes at least one first interconnection structure 31, and therefore, the top surface and the two opposite side surfaces of the second part C-2 of each collector C are in contact with the at least one first interconnection structure 31.

It may be understood that, as shown in FIG. 10A, when each collector C includes a plurality of fins, the first interconnection structure 31 is in contact with a top surface c1 and two opposite side faces c2s of a second part of each fin in the collector C.

In some embodiments, as shown in FIG. 10A, each second interconnection structure 32 is in contact with a top surface and two opposite side surfaces of the second part E-2 of each emitter E and a top surface and two opposite side surfaces of the second part B-2 of each base B.

It may be understood that, as shown in FIG. 10A, when each emitter E includes a plurality of fins, the second interconnection structure 32 is in contact with a top surface e1 and two opposite side faces e2 of a second part of each fin in the emitter E. When each base B includes a plurality of fins, the second interconnection structure 32 is in contact with a top surface b1 and two opposite side faces b2s of a second part of each fin in the base B.

Each second interconnection structure 32 is in contact with the top surface and the two opposite side surfaces of the second part E-2 of each emitter E and the top surface and the two opposite side surfaces of the second part B-2 of each base B, that is, an interconnection structure that is in contact with the emitter E and the base B is connected as an integrated structure. After the second interconnection structure 32 is powered on, channel inversion may be formed below the second interconnection structure 32, so that the channel is also used as an effective region of the emitter E, thereby further increasing an effective area of the emitter E.

Certainly, it may also be that a top surface and two opposite side surfaces of the second part E-2 of each emitter E are in contact with a third interconnection structure, and a top surface and two opposite side surfaces of the second part B-2 of each base B are in contact with a fourth interconnection structure.

That is, an interconnection structure in contact with the emitter E and an interconnection structure in contact with the base B are not connected.

In some embodiments, as shown in FIG. 10A and FIG. 10B, extension directions of the first interconnection structures 31 and the second interconnection structures 32 are the same, and each second interconnection structure 32 and one first interconnection structure 31 in each group are located on a same extension line. In this way, a layout of the first interconnection structure 31 and the second interconnection structure 32 is simple, and a preparation process can be simplified.

In some embodiments, a correspondence between the plurality of first interconnection structures 31 and the at least one second interconnection structure 32 in this example is as follows: The plurality of first interconnection structures 31 are divided into two groups, and a quantity of the first interconnection structures 31 in each group and a quantity of the second interconnection structures 32 are the same. In this way, a layout of the first interconnection structure 31 and the second interconnection structure 32 is simple, and a preparation process can be simplified.

In some embodiments, as shown in FIG. 10A and FIG. 10B, the plurality of first interconnection structures 31 have a same structure, and the plurality of second interconnection structures 32 have a same structure. In this way, a layout of the first interconnection structure 31 and the second interconnection structure 32 is simple, and a preparation process can be simplified.

In some embodiments, as shown in FIG. 10A and FIG. 10B, the plurality of first interconnection structures 31 and the at least one second interconnection structure 32 have a same size in the first direction X. In this way, a layout of the first interconnection structure 31 and the second interconnection structure 32 is simple, and a preparation process can be simplified.

In some embodiments, before the first interconnection structure 31 and the second interconnection structure 32 are formed, a dielectric layer (not shown in the figure) is further formed, and the dielectric layer is exactly located between the first interconnection structure 31 and the fin and between the second interconnection structure 32 and the fin. For example, the dielectric layer may be formed in the same photoetching and etching process with the first interconnection structure 31 and the second interconnection structure 32.

S70: As shown in FIG. 11, perform ion injection on the two collectors C, the plurality of emitters E, and the at least one base B, so that the two collectors C, the plurality of emitters E, and the at least one base B are converted from semiconductors to conductors.

Matching doping is performed on the two collectors C, the plurality of emitters E, and the at least one base B based on whether the FinBJT to be formed is of an NPN type or a PNP type.

For example, the FinBJT to be formed is an NPN-type structure. N-doped plus (N+) may be performed on the two collectors C. N-doped plus (N+) may be performed on the plurality of emitters E. P-doped plus (P+) may be performed on the at least one base B.

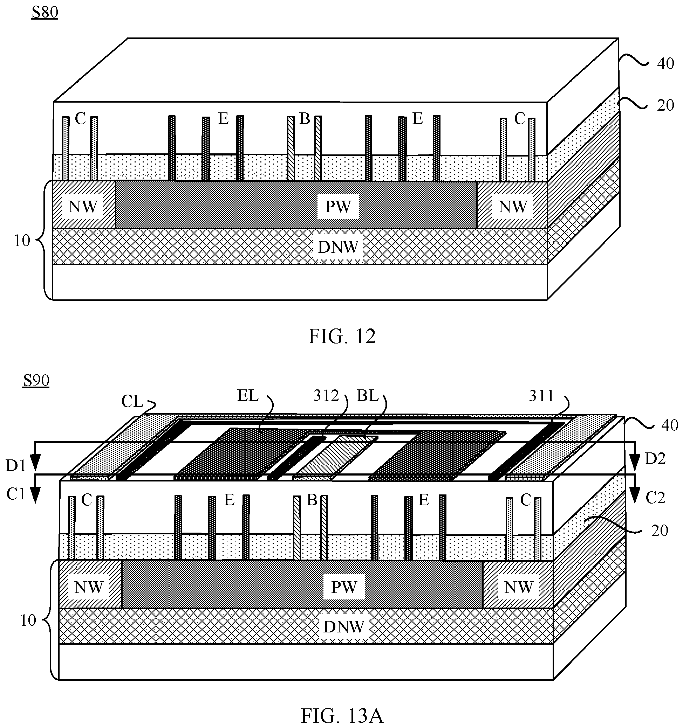

S80: As shown in FIG. 12, form a flattening layer 40 on the shallow groove isolation structure 20.

A material of the flattening layer 40 may be, for example, SiO₂, and the flattening layer 40 may be formed by using a deposition process. The flattening layer 40 covers the two collectors C, the plurality of emitters E, the at least one base B, the plurality of first interconnection structures 31, and the at least one second interconnection structure 32.

S90: As shown in FIG. 13A, form a collector line CL, an emitter line EL, a base line BL, a first interconnection structure line 311, and a second interconnection structure line 321 on the flattening layer 40.

The collector line CL is configured to perform collector signal transmission, the emitter line EL is configured to perform emitter signal transmission, the base line BL is configured to perform base signal transmission, the first interconnection structure line 311 is configured to prevent floating potential of the first interconnection structure 311, and the second interconnection structure line 312 is configured to prevent floating potential of the second interconnection structure 312.

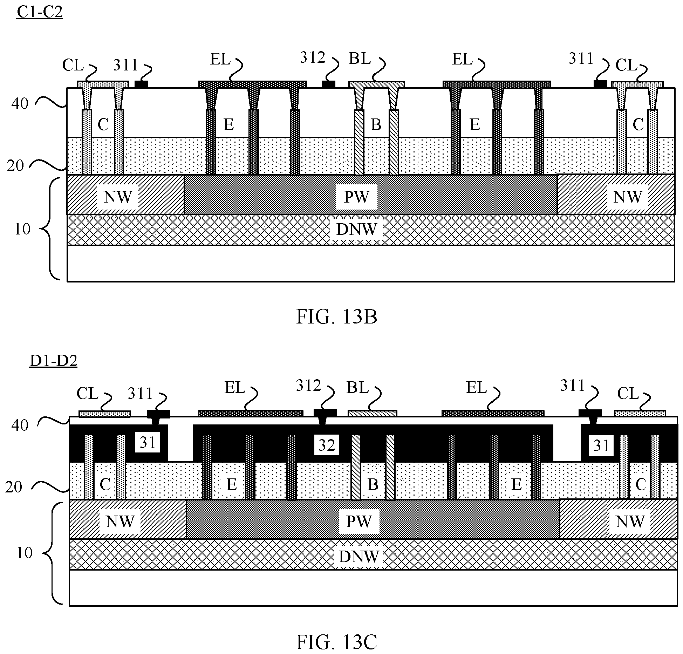

As shown in FIG. 13B (a sectional view along a C1-C2 direction in FIG. 13A), the collector line CL is disposed above the two collectors C (or understood as sides, of the collectors C, that are far away from the substrate 10), and is connected to and in contact with the two collectors C through a first via hole (not shown in the figure) in the flattening layer 40.

As shown in FIG. 13B, the emitter line EL is disposed above the plurality of emitters E (or understood as sides, of the emitters E, that are away from the substrate 10), and is connected to and in contact with the plurality of emitters E through the first via hole in the flattening layer 40.

As shown in FIG. 13B, the base line BL is disposed above the at least one base B (or understood as a side, of the base B, that is away from the substrate 10), and is connected to and in contact with the at least one base B through the first via hole in the flattening layer 40. It should be noted that, as shown in FIG. 13B, the first via hole, in the flattening layer 40, that is used to implement contact connection between the collector line CL and the collector C, the first via hole, in the flattening layer 40, that is used to implement contact connection between the emitter line EL and the emitter E, and the first via hole, in the flattening layer 40, that is used to implement contact connection between the base line BL and the base B are all staggered with the first interconnection structure 31 and the second interconnection structure 32. That is, orthographic projection of the first via hole on the substrate 10 does not overlap orthographic projection of the first interconnection structure 31 and the second interconnection structure 32 on the substrate 10.

Alternatively, it is understood that the first interconnection structure 31 is not disposed at a location at which the collector line CL is connected to and in contact with the collector C, and the second interconnection structure 32 is not disposed at a location at which the emitter line EL is connected to and in contact with the emitter E and at a location at which the base line BL is connected to and in contact with the base B.

A quantity of first via holes used to implement contact connection between the collector line CL and the collector C, a quantity of first via holes used to implement contact connection between the emitter line EL and the emitter E, and a quantity of first via holes used to implement contact connection between the base line BL and the base B are not limited in embodiments of this application, provided that each fin in each collector C is connected to and in contact with the collector line CL, each fin in each emitter E is connected to and in contact with the emitter line EL, and each fin in each base B is connected to and in contact with the base line BL.

As shown in FIG. 13C (a sectional view along a D1-D2 direction in FIG. 13A), the first interconnection structure line 311 is disposed above the first interconnection structures 31, and is connected to and in contact with the first interconnection structures 31 through a second via hole in the flattening layer 40.

As shown in FIG. 13C, the second interconnection structure line 321 is disposed above the second interconnection structure 32, and is connected to and in contact with the second interconnection structure 32 through the second via hole in the flattening layer 40.

Similarly, a quantity of second via holes used to implement contact connection between the first interconnection structure line 311 and the first interconnection structure line 31 and a quantity of second via holes used to implement contact connection between the second interconnection structure line 321 and the second interconnection structure 32 are not limited in embodiments of this application, provided that each first interconnection structure 31 is connected to and in contact with the first interconnection structure line 311 and each second interconnection structure 32 is connected to and in contact with the second interconnection structure line 321.

The collector line CL, the emitter line EL, the base line BL, the first interconnection structure line 311, and the second interconnection structure line 321 may be formed in a same step in a same process (for example, the photoetching and etching process), or may be formed step by step in different processes. This is not limited in embodiments of this application.

Materials of the collector line CL, the emitter line EL, the base line BL, the first interconnection structure line 311, and the second interconnection structure line 321 may be, for example, metals.

In some embodiments, as shown in FIG. 13A, the collector line CL, the emitter line EL, the base line BL, the first interconnection structure line 311, and the second interconnection structure line 321 in the FinBJT may each be of a continuous segment of structure.

One collector line CL is connected to and in contact with the two collectors C, one emitter line EL is connected to and in contact with the plurality of emitters E, one base line BL is connected to and in contact with each fin in the at least one base B, one first interconnection structure line 311 is connected to and in contact with the plurality of first interconnection structures 31, and one second interconnection structure line 321 is connected to and in contact with the plurality of second interconnection structures 32.

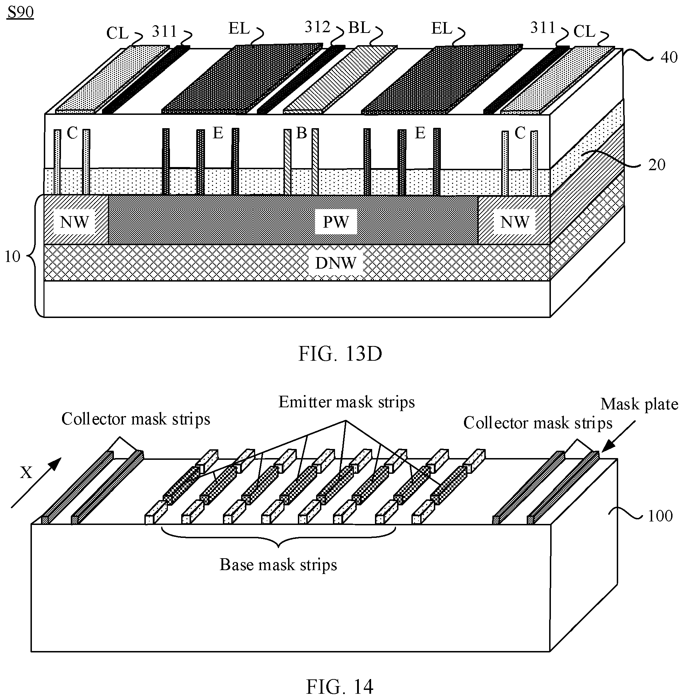

In some other embodiments, as shown in FIG. 13D, the collector line CL, the emitter line EL, and the first interconnection structure line 311 in the FinBJT may be of a multi-segment structure.

One or more collectors C correspond one segment of the disposed collector line CL, one or more emitters E correspond to one segment of the emitter line EL, and one or more groups of first interconnection structures 31 correspond to one segment of the first interconnection structure line 311.

A specific arrangement manner of the collector line CL, the emitter line EL, the base line BL, the first interconnection structure line 311, and the second interconnection structure line 321 is not limited in embodiments of this application, and may be appropriately disposed according to a requirement. The collector line CL, the emitter line EL, the base line BL, the first interconnection structure line 311, and the second interconnection structure line 321 may be disposed at a same layer, or may be disposed at different layers.

In this example, the plurality of emitters E and the at least one base B are all located between the two collectors C, each collector C is adjacent to one of the plurality of emitters E, and the base B is disposed between the adjacent emitters E, so that the emitter E is disposed closer to the collector C, the emitter E has larger layout space, and an area proportion of the emitter E can be increased. In addition, there are the plurality of emitters E, and the at least one base B. A quantity of the emitters E is greater than a quantity of the bases B, and an area proportion of the emitter E can be increased.

Therefore, in a same area, this arrangement manner of the emitter E and the base B provided in this example can enable the area proportion of the emitter E to reach 49.1%, and increase a current driving capability of the FinBJT. In addition, when a collection capability of the collector C is not saturated, increasing the area of the emitter E can increase a current (beta) gain of the FinBJT. The current gain is a current amplification capability of the BJT, that is, a ratio of an output current to an input current. A larger current gain indicates a higher amplification characteristic of the BJT. Therefore, the FinBJT provided in this example has a higher current gain and a higher amplification characteristic. With a same current driving capability and current gain, this arrangement manner of the emitter E and the base B provided in this example enables the FinBJT to have a smaller area and higher integration.

In addition, it can be learned from the foregoing descriptions that a conventional process is used during preparation of the FinBJT. In other words, in embodiments of this application, the FinBJT can be prepared by using a conventional process, without a complex and high-cost process or a new process to be developed. Therefore, the preparation method of the FinBJT provided in embodiments of this application has low costs, and can be used for mass production of the FinBJT. Further, the FinBJT prepared in the preparation method of the FinBJT provided in embodiments of this application has a strong current driving capability.

### Example 2

A difference between Example 2 and Example 1 lies in that in Example 1, the plurality of emitters E and the at least one base B in the FinBJT are arranged along the direction (the second direction) perpendicular to the extension direction of the collector C; and in this example, at least one emitter E and a plurality of bases B in a FinBJT are arranged along an extension direction (the first direction) of a collector C. That is, different quantities of emitters E and bases B correspond to different arrangement manners.

The FinBJT in this example may be prepared in the preparation method of the FinBJT shown in Example 1. A main difference between Example 2 and Example 1 lies in that, as shown in FIG. 14, a mask plate formed in step S10 includes two groups of collector mask strips, at least one group of emitter mask strips, and a plurality of groups of base mask strips.

The at least one group of emitter mask strips and the plurality of groups of base mask strips are located between the two groups of collector mask strips, and the at least one group of emitter mask strips and the plurality of groups of base mask strips are arranged along the extension direction of the collector. Along the extension direction (the first direction X) of the collector mask strip, a group of emitter mask strips is disposed between two adjacent groups of base mask strips, and an outermost side is a group of base mask strips.

A length of the emitter mask strip is greater than a length of the base mask strip, and is less than a length of the collector mask strip.

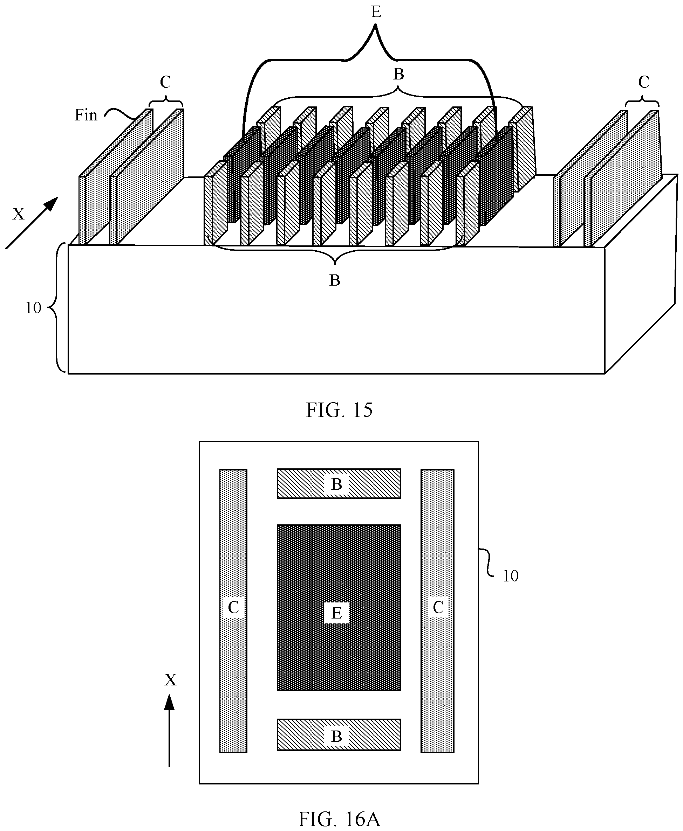

It should be noted that, in FIG. 15, to clearly show the collector mask strip, the emitter mask strip, and the base mask strip, different patterns are used to fill the three mask strips. The three mask strips are not limited to be different materials, and all the three mask strips may be obtained through preparation by using SiO₂.

A step of preparing the mask plate in Example 2 may be the same as that in Example 1, but a pattern of the finally prepared mask plate is different from that in Example 1.

Based on this, in different mask plates, arrangement manners of the prepared collector C, emitter E, and base B are also different.

A FinBJT is provided. As shown in FIG. 15, the FinBJT mainly includes a substrate 10, the two collectors C, the at least one emitter E, and the plurality of bases B. The two collectors C, the at least one emitter E, and the plurality of bases B are all disposed on the substrate 10.

The two collectors C are disposed in parallel, the at least one emitter E and the plurality of bases B are all located between the two collectors C, and the at least one emitter E and the plurality of bases B are arranged along the extension direction (the first direction X) of the collector E. Along the extension direction of the collector E, the emitter E is disposed between adj acent base B, and the base B is located on the outermost side.

It should be understood that, as shown in FIG. 15, in the preparation method that is the same as that in Example 1, the prepared collector C, emitter E, and base B each include at least one fin. Fins in the collector C, the emitter E, and the base B have a same extension direction, but have different lengths.

In FIG. 15, that the FinBJT includes two collectors C, one emitter E, and two bases B is used as an example for illustration. Each collector C includes two fins, each emitter E includes eight fins, and each base B includes eight fins. Structures of the collector C, the emitter E, and the base B in the FinBJT are described below in detail. Details are not described herein.

In some embodiments, as shown in FIG. 15, a length (size in the first direction X) of the fin in the emitter E is greater than a length of the fin in the base B. The length of the fin in the emitter E is greater than the length of the fin in the base B, and this can increase an area proportion of the emitter E.

In some embodiments, as shown in FIG. 15, a quantity of fins in each emitter E is equal to a quantity of fins in each base B. In this way, preparation of the fin is convenient, and a preparation process can be simplified.

In some embodiments, as shown in FIG. 15, fins in all emitters E have an equal length, fins in all bases B have an equal length, and fins in all collectors C have an equal length. In this way, preparation of the fin is convenient, and the preparation process can be simplified.

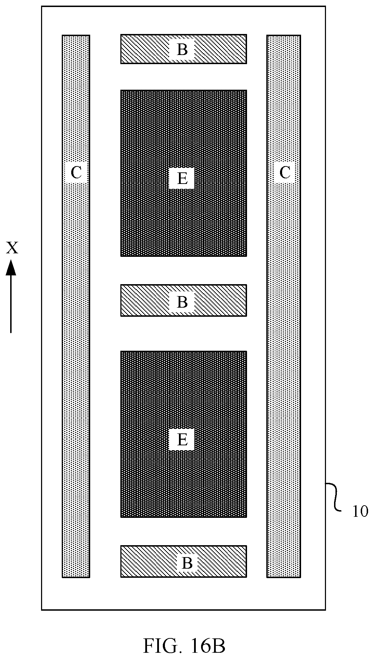

A quantity of the at least one emitter E and a quantity of the plurality of bases B are not limited. As shown in FIG. 16A and FIG. 16B, the quantity of the bases B is one more than the quantity of the emitters E.

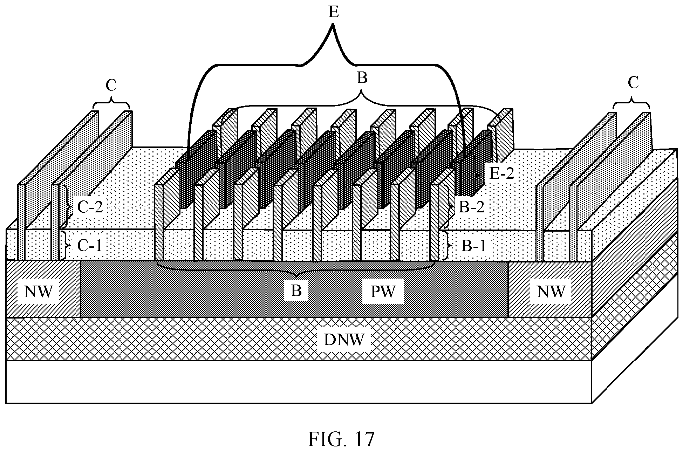

In some embodiments, as shown in FIG. 17, a structure of the substrate 10 may be the same as that of the substrate 10 in Example 1. Details are not described herein again.

In some embodiments, as shown in FIG. 17, the FinBJT further includes a shallow groove isolation structure 20. The shallow groove isolation structure 20 is disposed on the substrate 10.

The shallow groove isolation structure 20 wraps a first part, of the two collectors C, the at least one emitter E, and the plurality of bases B respectively, that is close to the substrate 10, and the shallow groove isolation structure 20 exposes a second part, of the two collectors C, the at least one emitter E, and the plurality of bases B respectively, that is away from the substrate 10.

That is, as shown in FIG. 17, the shallow groove isolation structure 20 wraps a first part C-1, of each collector C, that is close to the substrate 10, and exposes a second part C-2, of each collector C, that is away from the substrate 10. Alternatively, it is understood that each collector C includes a first part C-1 buried in the shallow groove isolation structure 20 and a second part C-2 exposed to the shallow groove isolation structure 20. For ease of illustration, the first part C-1 and the second part C-2 of the collector C are marked on one fin in the collector C in FIG. 17.

The shallow groove isolation structure 20 wraps a first part E-1, of each emitter E, that is close to the substrate 10, and exposes a second part E-2, of each emitter E, that is away from the substrate 10. Alternatively, it is understood that each emitter E includes a first part E-1 buried in the shallow groove isolation structure 20 and a second part E-2 exposed to the shallow groove isolation structure 20. For ease of illustration, the first part E-1 and the second part E-2 of the emitter E are marked on one fin in the emitter E in FIG. 17.

The shallow groove isolation structure 20 wraps a first part B-1, of each base B, that is close to the substrate 10, and exposes a second part B-2, of each base B, that is away from the substrate 10. Alternatively, it is understood that each base B includes a first part B-1 buried in the shallow groove isolation structure 20 and a second part B-2 exposed to the shallow groove isolation structure 20. For ease of illustration, the first part B-1 and the second part B-2 of the base B are marked on one fin in the base B in FIG. 17.

A structure of the shallow groove isolation structure 20 in this example is the same as that in Example 1. For details, refer to the foregoing related descriptions. Details are not described herein again.

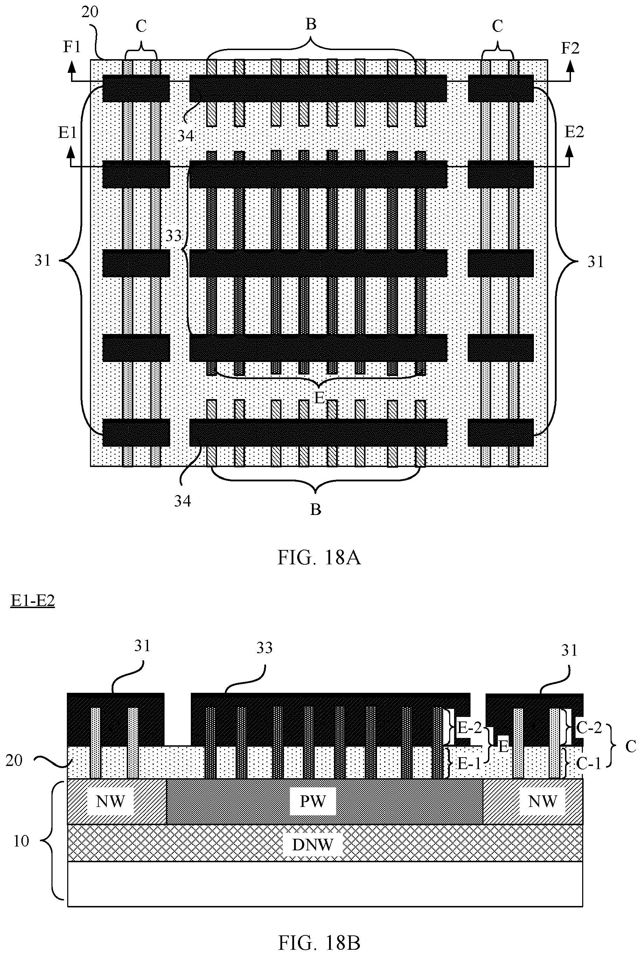

In some embodiments, as shown in FIG. 18A, the FinBJT further includes a plurality of first interconnection structures 31, at least one third interconnection structure 33, and a plurality of fourth interconnection structures 34 that are disposed on the shallow groove isolation structure 20.

Extension directions of the plurality of first interconnection structures 31, the at least one third interconnection structure 33, and the plurality of fourth interconnection structures 34 intersect with (for example, are perpendicular to) the extension direction of the collector E.

As shown in FIG. 18B (a sectional view along an E1-E2 direction in FIG. 18A), a top surface and two opposite side surfaces of the second part C-2 of each collector C are in contact with at least one first interconnection structure 31.

As shown in FIG. 18B, a top surface and two opposite side surfaces of the second part E-2 of each emitter E are in contact with at least one third interconnection structure 33.

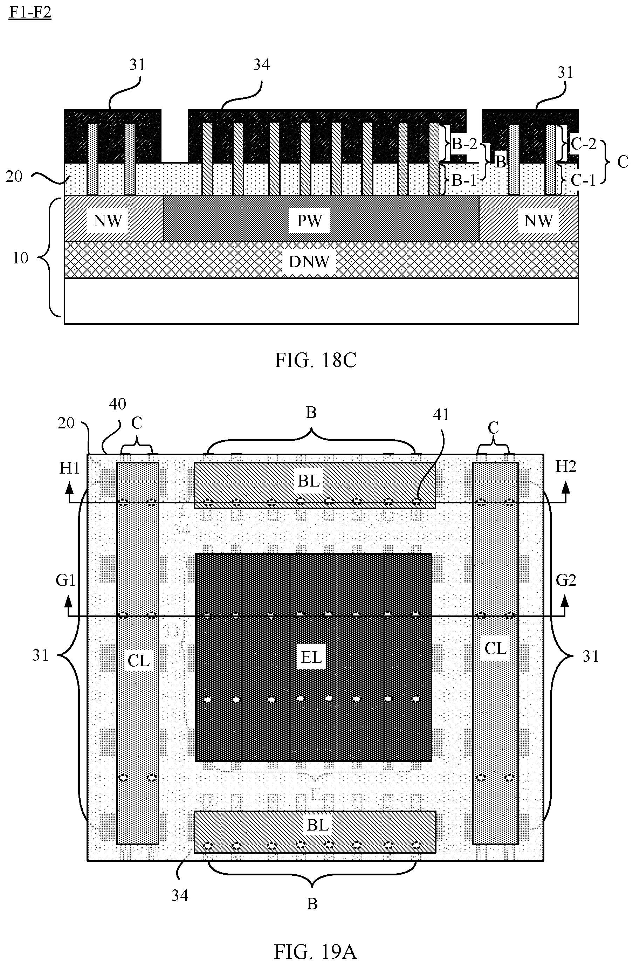

As shown in FIG. 18C (a sectional view along an F1-F2 direction in FIG. 18A), a top surface and two opposite side surfaces of the second part B-2 of each base B are in contact with at least one fourth interconnection structure 34.

In some embodiments, a top surface and two opposite side surfaces of the second part B-2 of each base B are in contact with one fourth interconnection structure 34.

For example, as shown in FIG. 18A, the FinBJT includes two bases B and two fourth interconnection structures 34, and one base B and one fourth interconnection structure 34 are disposed correspondingly.

When space between adjacent collectors C is fixed, each base B is in contact with only one fourth interconnection structure 34, so as to minimize an area of the base B. Remaining space can be reserved to dispose the emitter C, and this increases an area proportion of the emitter C.

In some embodiments, as shown in FIG. 19A, the FinBJT further includes a flattening layer 40 and a collector line CL, an emitter line EL, and a base line BL that are disposed on the flattening layer 40.

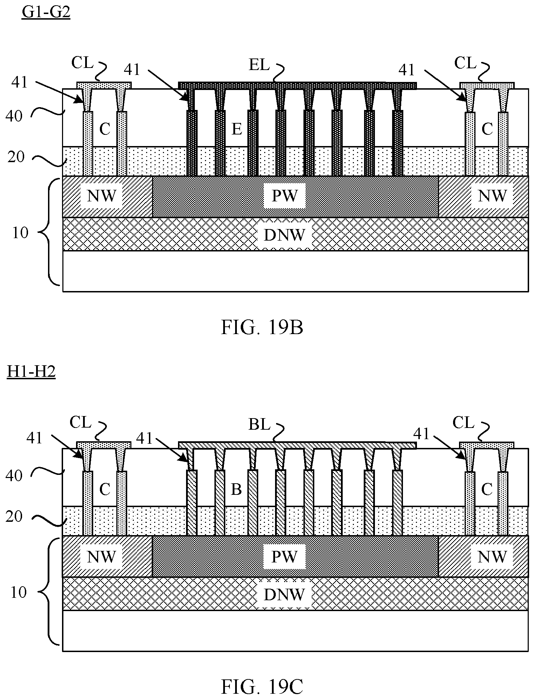

As shown in FIG. 19B (a sectional view along a G1-G2 direction in FIG. 19A), the collector line CL is disposed above the two collectors C, and is connected to and in contact with the two collectors C through a first via hole 41 in the flattening layer 40.

As shown in FIG. 19B, the emitter line EL is disposed above the at least one emitter E, and is connected to and in contact with the at least one emitter E through the first via hole 41 in the flattening layer 40.

As shown in FIG. 19C (a sectional view along an H1-H2 direction in FIG. 19A), the base line BL is disposed above the plurality bases B, and is connected to and in contact with the plurality bases B through the first via hole 41 in the flattening layer 40.

As shown in FIG. 19A, the first via hole 41, in the flattening layer 40, that is used to implement contact connection between the collector line CL and the collector C, the first via hole 41 that is used to implement contact connection between the emitter line EL and the emitter E, and the first via hole 41 that is used to implement contact connection between the base line BL and the base B are all staggered with the first interconnection structure 31, the third interconnection structure 33, and the fourth interconnection structure 34. That is, orthographic projection of the first via hole 41 on the substrate 10 does not overlap orthographic projection of the first interconnection structure 31, the third interconnection structure 33, and the fourth interconnection structure 34 on the substrate 10.

Alternatively, it is understood that the first interconnection structure 31 is not disposed at a location at which the collector line CL is connected to and in contact with the collector C, the third interconnection structure 33 is not disposed at a location at which the emitter line EL is connected to and in contact with the emitter E, and the fourth interconnection structure 34 is not disposed at a location at which the base line BL is connected to and in contact with the base B.

A quantity of first via holes 41 used to implement contact connection between the collector line CL and the collector C, a quantity of first via holes 41 used to implement contact connection between the emitter line EL and the emitter E, and a quantity of first via holes 41 used to implement contact connection between the base line BL and the base B are not limited in embodiments of this application, provided that each fin in each collector C is connected to and in contact with the collector line CL, each fin in each emitter E is connected to and in contact with the emitter line EL, and each fin in each base B is connected to and in contact with the base line BL.

In some embodiments, the FinBJT further includes a first interconnection structure line, a third interconnection structure line, and a fourth interconnection structure line disposed on the flattening layer.

The first interconnection structure line is disposed above the first interconnection structure 31, and is connected to and in contact with the first interconnection structure 31 through a second via hole in the flattening layer 40.

The third interconnection structure line is disposed above the third interconnection structure 33, and is connected to and in contact with the third interconnection structure 33 through the second via hole in the flattening layer 40.

The fourth interconnection structure line is disposed above the fourth interconnection structure 34, and is connected to and in contact with the fourth interconnection structure 34 through the second via hole in the flattening layer 40.

Similarly, a quantity of second via holes used to implement contact connection between the first interconnection structure line and the first interconnection structure line 31, a quantity of second via holes used to implement contact connection between the third interconnection structure line and the third interconnection structure, and a quantity of second via holes used to implement contact connection between the fourth interconnection structure line and the fourth interconnection structure are not limited in embodiments of this application, provided that each first interconnection structure 31 is connected to and in contact with the first interconnection structure line, each third interconnection structure 33 is connected to and in contact with the third interconnection structure line, and each fourth interconnection structure 34 is connected to and in contact with the fourth interconnection structure line.

In this example, the at least one emitter E and the plurality of bases B are all located between the two collectors C, and the at least one emitter E and the plurality of bases B are arranged along the extension direction (the first direction X) of the collector E. In this arrangement manner, a spacing between the emitter E and the base B is located in the extension direction (the first direction X) of the collector E, and is no longer located in the second direction Y In the second direction Y, in addition to a spacing between fins, only a spacing between the emitter E (or the base B) and the collector C is included, and the spacing between the emitter E and the base B is not included. Therefore, integration of the FinBJT can be improved and an area of an integrated circuit can be reduced in a manner in which a size in the first direction X is not increased and a size in the second direction Y is reduced.

In addition, in this example, the arrangement manner in which the at least one emitter E and the plurality of bases B are arranged along the extension direction (the first direction X) of the collector E can increase a quantity of fins in the emitter E, and reduce a length of the fin in the emitter E. This is equivalent to increasing a width of the emitter E, and reducing a length of the emitter E; and is equivalent to changing a shape of the emitter E from a rectangle to a square. When a sum of a length and a width is fixed, an area of the square is greater than an area of the rectangle (for example, 4*4 is greater than 3*5). This can increase the area proportion of the emitter E. For example, eight fins are disposed between the two collectors C, and an area of a top surface of each fin is 2*5=10 nm². If the arrangement manner shown in FIG. 2A is used, an area of the emitter E is 4*10=40 nm². If the arrangement manner shown in FIG. 15 in this example is used, a length of the emitter E is 3 nm, a length of each base E is 1 nm, and an area of the emitter E is 8*(2*3)=48 nm².

Therefore, in a same area, this arrangement manner of the emitter E and the base B provided in this example can enable the area proportion of the emitter E to reach 53.2%, and increase a current driving capability of the FinBJT. In addition, when a collection capability of the collector C is not saturated, increasing the area of the emitter E can increase a current (beta) gain of the FinBJT. Therefore, the FinBJT provided in this example has a higher current gain and a higher amplification characteristic. With a same current driving capability and current gain, this arrangement manner of the emitter E and the base B provided in this example enables the FinBJT to have a smaller area and higher integration.

In addition, it can be learned from the foregoing descriptions that a conventional process is used during preparation of the FinBJT. In other words, in embodiments of this application, the FinBJT can be prepared by using a conventional process, without a complex and high-cost process or a new process to be developed. Therefore, the preparation method of the FinBJT provided in embodiments of this application has low costs, and can be used for mass production of the FinBJT. Further, the FinBJT prepared in the preparation method of the FinBJT provided in embodiments of this application has high integration and a strong current driving capability.

### Example 3

A main difference between Example 3 and Example 1 lies in that in Example 1, the plurality of emitters E and the at least one base B in the FinBJT are arranged along the direction perpendicular to the extension direction of the collector C; and in this example, a plurality of emitters E and at least one base B in a FinBJT are arranged along an extension direction of a collector C, that is, arrangement manners of the emitter E and the base B are different.

A main difference between Example 3 and Example 2 lies in that: In Example 2, the FinBJT includes the at least one emitter E and the plurality of bases B; and in this example, the FinBJT includes the plurality of emitters E and the at least one base B, that is, a quantity of emitters E is different from a quantity of bases B.

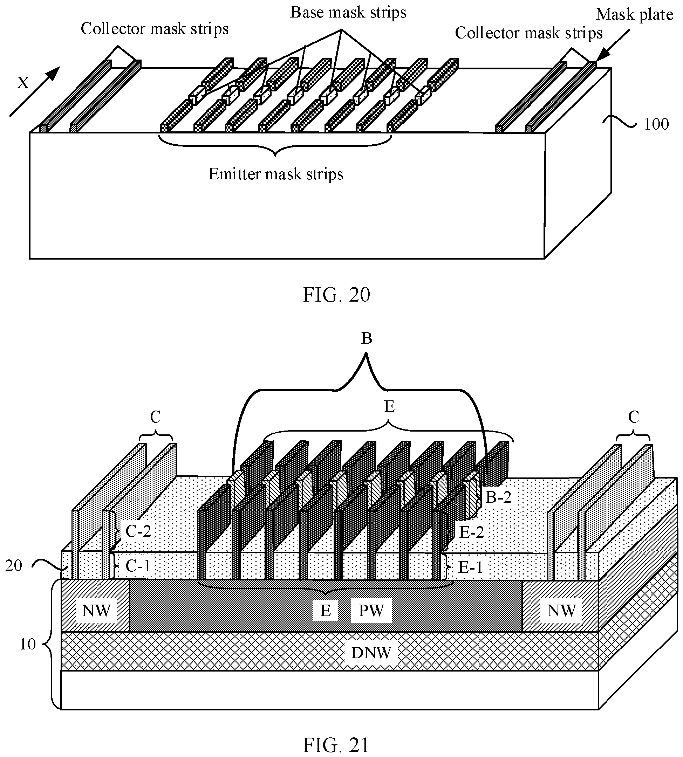

The FinBJT in this example may be prepared in the preparation method of the FinBJT shown in Example 1. A main difference between Example 2 and Example 1 lies in that, as shown in FIG. 20, a mask plate formed in step S10 includes two groups of collector mask strips, a plurality of groups of emitter mask strips, and at least one group of base mask strips.

The plurality of groups of emitter mask strips and the at least one group of base mask strips are located between the two groups of collector mask strips, and the plurality of groups of emitter mask strips and the at least one group of base mask strips are arranged along the extension direction of the collector. Along the extension direction (the first direction X) of the collector mask strip, a group of base mask strips is disposed between two adjacent groups of emitter mask strips, and an outermost side is a group of emitter mask strips.

A length of the emitter mask strip is greater than a length of the base mask strip, and is less than a length of the collector mask strip.

It should be noted that, in FIG. 20, to clearly show the collector mask strip, the emitter mask strip, and the base mask strip, different patterns are used to fill the three mask strips. The three mask strips are not limited to be different materials, and all the three mask strips may be obtained through preparation by using SiO₂.

A step of preparing the mask plate in Example 3 may be the same as that in Example 1, but a pattern of the finally prepared mask plate is different from that in Example 1.

Based on this, in different mask plates, arrangement manners of the prepared collector C, emitter E, and base B are also different.

A FinBJT is provided. As shown in FIG. 21, the FinBJT mainly includes a substrate 10, the two collectors C, the plurality of emitters E, and the at least one base B. The two collectors C, the plurality of emitters E, and the at least one base B are all disposed on the substrate 10.

The two collectors C are disposed in parallel, the plurality of emitters E and the at least one base B are all located between the two collectors C, and the plurality of emitters E and the at least one base B are arranged along the extension direction (the first direction X) of the collector E. Along the extension direction of the collector E, a base B is disposed between adjacent emitters E, and the emitter E is located on an outermost side.

It should be understood that, as shown in FIG. 21, in the preparation method that is the same as that in Example 1, the prepared collector C, emitter E, and base B each include at least one fin. Fins in the collector C, the emitter E, and the base B have a same extension direction, but have different lengths.

In FIG. 21, that the FinBJT includes two collectors C, two emitters E, and one base B is used as an example for illustration. Each collector C includes two fins, each emitter E includes eight fins, and each base B includes eight fins. Structures of the collector C, the emitter E, and the base B in the FinBJT are described below in detail. Details are not described herein.

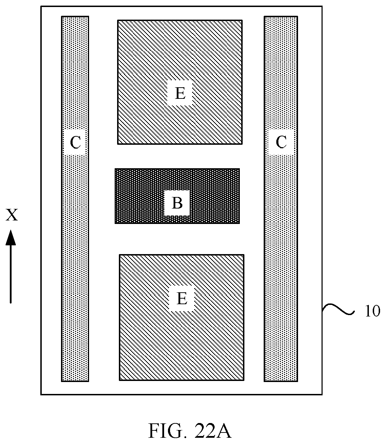

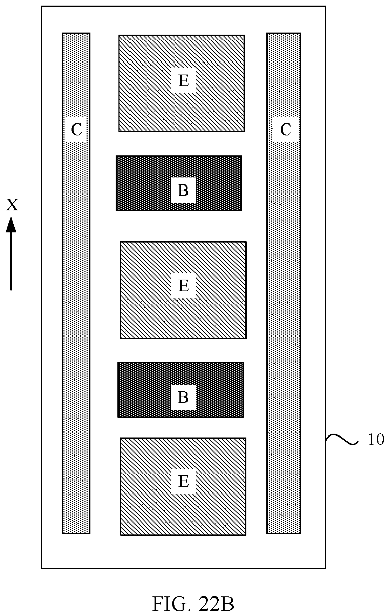

A quantity of the plurality of emitters E and a quantity of the at least one base B are not limited. As shown in FIG. 22A and FIG. 22B, the quantity of the emitters E is one more than the quantity of the bases B.

In this example, structures of the emitter E, the base B, and the collector C may be the same as those in Example 2. For details, refer to related descriptions in Example 2, but arrangement manners of the emitter E and the base B are different.

In some embodiments, as shown in FIG. 21, the FinBJT further includes a shallow groove isolation structure 20. The shallow groove isolation structure 20 is disposed on the substrate 10.

The shallow groove isolation structure 20 wraps a first part, of the two collectors C, the plurality of emitters E, and the at least one base B respectively, that is close to the substrate 10. The shallow groove isolation structure 20 exposes a second part, of the two collectors C, the plurality of emitters E, and the at least one base B respectively, that is away from the substrate 10.

A structure of the shallow groove isolation structure 20 in this example is the same as that in Example 1 and Example 2. For details, refer to the foregoing related descriptions. Details are not described herein again.

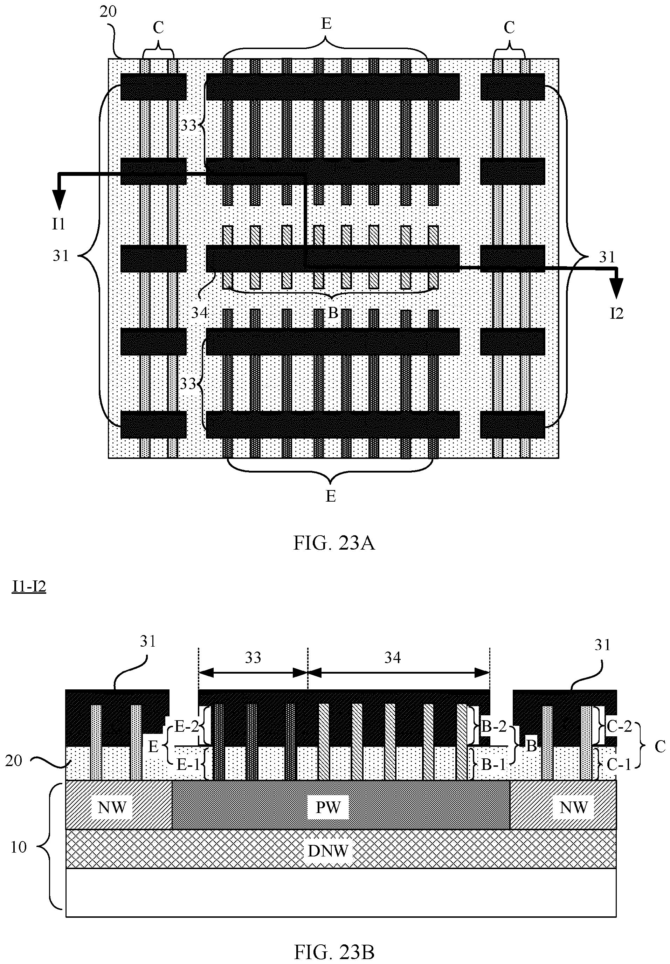

In some embodiments, as shown in FIG. 23A, the FinBJT further includes a plurality of first interconnection structures 31, a plurality of third interconnection structures 33, and at least one fourth interconnection structure 34 that are disposed on the shallow groove isolation structure 20.

Extension directions of the plurality of first interconnection structures 31, the plurality of third interconnection structures 33, and the at least one fourth interconnection structure 34 intersect with (for example, are perpendicular to) the extension direction of the collector E.

As shown in FIG. 23B (a sectional view along an I1-I2 direction in FIG. 23A), a top surface and two opposite side surfaces of the second part C-2 of each collector C are in contact with at least one first interconnection structure 31.

As shown in FIG. 23B, a top surface and two opposite side surfaces of the second part E-2 of each emitter E are in contact with at least one third interconnection structure 33.

As shown in FIG. 23B, a top surface and two opposite side surfaces of the second part B-2 of each base B are in contact with the at least one fourth interconnection structure 34.

In some embodiments, a top surface and two opposite side surfaces of the second part B-2 of each base B are in contact with one fourth interconnection structure 34. That is, a quantity of bases B is equal to a quantity of the fourth interconnection structures 34. For example, as shown in FIG. 23A, the FinBJT includes one base B and one fourth interconnection structure 34.

When space between adjacent collectors C is fixed, each base B is in contact with only one fourth interconnection structure 34, so as to minimize an area of the base B. Remaining space can be reserved to dispose the emitter C, and this increases an area proportion of the emitter C.

In some embodiments, the FinBJT further includes a flattening layer 40, and a collector line CL, an emitter line EL, a base line BL, a first interconnection structure line, a third interconnection structure line, and a fourth interconnection structure line that are disposed on the flattening layer 40.

In this example, structures of the collector line CL, the emitter line EL, the base line BL, the first interconnection structure line, the third interconnection structure line, and the fourth interconnection structure line are the same as those in Example 2. For details, refer to the foregoing related descriptions. Details are not described herein again.

In this example, the plurality of emitters E and the at least one base B are all located between the two collectors C, and the plurality of emitters E and the at least one base B are arranged along the extension direction (the first direction X) of the collector E. In this arrangement manner, a spacing between the emitter E and the base B is located in the extension direction (the first direction X) of the collector E, and is no longer located in the second direction Y In the second direction Y, in addition to a spacing between fins, only a spacing between the emitter E (or the base B) and the collector C is included, and the spacing between the emitter E and the base B is not included. Therefore, integration of the FinBJT can be improved and an area of an integrated circuit can be reduced in a manner in which a size in the first direction X is not increased and a size in the second direction Y is reduced.

In addition, in this example, the arrangement manner in which the plurality of emitters E and the at least one base B are arranged along the extension direction (the first direction X) of the collector E can increase a quantity of fins in the emitter E, and reduce a length of the fin in the emitter E. This is equivalent to increasing a width of the emitter E, and reducing a length of the emitter E; and is equivalent to changing a shape of the emitter E from a rectangle to a square. When a sum of a length and a width is fixed, an area of the square is greater than an area of the rectangle (for example, 4*4 is greater than 3*5). This can increase the area proportion of the emitter E. For example, eight fins are disposed between the two collectors C, and an area of a top surface of each fin is 2*5=10 nm². If the arrangement manner shown in FIG. 2A is used, an area of the emitter E is 4*10=40 nm². If the arrangement manner shown in FIG. 21 in this example is used, a length of each emitter E is 2 nm, a length of a base E is 1 nm, and an area of the emitter E is 8*(2*2)*2=64 nm².

Therefore, in a same area, this arrangement manner of the emitter E and the base B provided in this example can enable the area proportion of the emitter E to reach 54.6%, and increase a current driving capability of the FinBJT. In addition, when a collection capability of the collector C is not saturated, increasing the area of the emitter E can increase a current (beta) gain of the FinBJT. Therefore, the FinBJT provided in this example has a higher current gain and a higher amplification characteristic. With a same current driving capability and current gain, this arrangement manner of the emitter E and the base B provided in this example enables the FinBJT to have a smaller area and higher integration.

In addition, it can be learned from the foregoing descriptions that a conventional process is used during preparation of the FinBJT. In other words, in embodiments of this application, the FinBJT can be prepared by using a conventional process, without a complex and high-cost process or a new process to be developed. Therefore, the preparation method of the FinBJT provided in embodiments of this application has low costs, and can be used for mass production of the FinBJT. Further, the FinBJT prepared in the preparation method of the FinBJT provided in embodiments of this application has high integration and a strong current driving capability.

Any one of the foregoing FinBJTs shown in embodiments of this application may be used in an integrated circuit, and therefore be used in an electronic device.

In some embodiments, a transistor included in the integrated circuit is the FinBJT.

Beneficial effect of the integrated circuit including the FinBJT and the electronic device having the integrated circuit is the same as the beneficial effect of the FinBJT. Details are not described herein again.

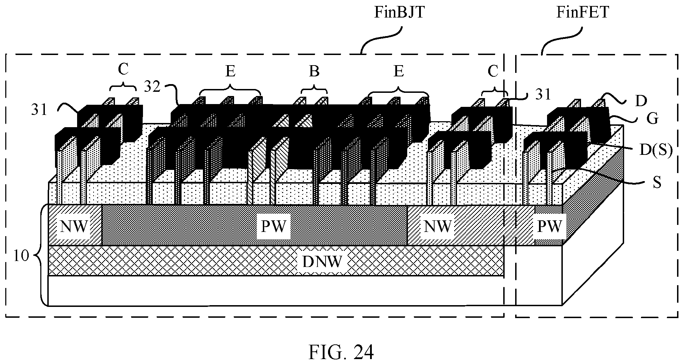

In some other embodiments, as shown in FIG. 24, an integrated circuit includes the FinBJT and a FinFET.

For example, the fins that are used as the emitter E, the base B, and the collector C in the FinBJT and fins that are used as a source S, a drain D, and a channel in the FinFET may be formed synchronously. The first interconnection structure 31 and the second interconnection structure 32 (or the third interconnection structure 33 and the fourth interconnection structure 34) in the FinBJT and a gate G in the FinFET are disposed at a same layer, and are formed synchronously.

The FinBJT and the FinFET are integrated on a same substrate 10, so that the integrated circuit can have features of both the FinBJT and the FinFET, thereby improving performance of the integrated circuit.

The foregoing descriptions are merely specific implementations of this application, but are not intended to limit the protection scope of this application. Any variation or replacement readily figured out by persons skilled in the art within the technical scope disclosed in this application shall fall within the protection scope of this application. Therefore, the protection scope of this application shall be subject to the protection scope of the claims.

## Claims

1. A fin-bipolar junction transistor FinBJT, comprising:
a substrate;
two collectors, disposed on the substrate, wherein the two collectors are disposed in parallel;
a plurality of emitters, disposed on the substrate; and
at least one base, disposed on the substrate, wherein
the plurality of emitters and the at least one base are all located between the two collectors, each collector is adjacent to one of the plurality of emitters, and the base is disposed between adjacent emitters.

2. The FinBJT according to claim 1, wherein the plurality of emitters, the at least one base, and the two collectors are disposed in parallel; and
along an extension direction of the collector, the plurality of emitters, the at least one base, and the two collectors have equal lengths.

3. The FinBJT according to claim 1 or 2, wherein each emitter comprises at least three fins.

4. The FinBJT according to any one of claims 1 to 3, wherein the FinBJT further comprises:
a collector line, disposed on the two collectors, and connected to and in contact with the two collectors;
an emitter line, disposed on the plurality of emitters, and connected to and in contact with the plurality of emitters; and
a base line, disposed on the at least one base, and connected to and in contact with the at least one base.

5. The FinBJT according to any one of claims 1 to 4, wherein the FinBJT further comprises a shallow groove isolation structure, and the shallow groove isolation structure is disposed on the substrate; and
the shallow groove isolation structure wraps a first part, of the two collectors, the plurality of emitters, and the at least one base respectively, that is close to the substrate, and exposes a second part, of the two collectors, the plurality of emitters, and the at least one base respectively, that is away from the substrate.

6. The FinBJT according to claim 5, wherein the FinBJT further comprises a plurality of first interconnection structures and at least one second interconnection structure that are disposed on the shallow groove isolation structure;
extension directions of the plurality of first interconnection structures and the at least one second interconnection structure intersect with the extension direction of the collector;
a top surface and two opposite side surfaces of the second part of each collector are in contact with at least one first interconnection structure; and
each second interconnection structure is in contact with a top surface and two opposite side surfaces of the second part of each emitter and a top surface and two opposite side surfaces of the second part of each base.

7. A preparation method of a fin-bipolar junction transistor FinBJT, comprising:
forming a mask plate on a basement; and
etching, a part, of the basement, that is not covered by the mask plate, to form a substrate, and two collectors, a plurality of emitters, and at least one base that are located on the substrate, wherein
the plurality of emitters and the at least one base are all located between the two collectors, each collector is adjacent to one of the plurality of emitters, and the base is disposed between adjacent emitters.

8. The preparation method of the FinBJT according to claim 7, wherein the preparation method further comprises: forming a shallow groove isolation structure on the substrate, wherein
the shallow groove isolation structure wraps a first part, of the two collectors, the plurality of emitters, and the at least one base respectively, that is close to the substrate, and exposes a second part, of the two collectors, the plurality of emitters, and the at least one base respectively, that is away from the substrate.

9. The preparation method of the FinBJT according to claim 8, wherein the preparation method further comprises:
forming a plurality of first interconnection structures and at least one second interconnection structure on the shallow groove isolation structure, wherein
extension directions of the plurality of first interconnection structures and the at least one second interconnection structure intersect with an extension direction of the collector; a top surface and two opposite side surfaces of the second part of each collector are in contact with at least one first interconnection structure; and each second interconnection structure is in contact with a top surface and two opposite side surfaces of the second part of each emitter and a top surface and two opposite side surfaces of the second part of each base.

10. The preparation method of the FinBJT according to claim 9, wherein after the plurality of first interconnection structures and the at least one second interconnection structure are formed, the preparation method further comprises:
forming a collector line, an emitter line, and a base line, wherein
the collector line is connected to and in contact with the two collectors, the emitter line is connected to and in contact with the plurality of emitters, and the base line is connected to and in contact with the at least one base.

11. A fin-bipolar junction transistor FinBJT, comprising:
a substrate;
two collectors, disposed on the substrate, wherein the two collectors are disposed in parallel;
at least one emitter, disposed on the substrate; and
a plurality of bases, disposed on the substrate, wherein
the at least one emitter and the plurality of bases are all located between the two collectors and arranged along an extension direction of the collector; and along the extension direction of the collector, the emitter is disposed between adjacent bases, and the base is located on an outermost side.

12. The FinBJT according to claim 11, wherein the FinBJT further comprises a shallow groove isolation structure, and the shallow groove isolation structure is disposed on the substrate; and
the shallow groove isolation structure wraps a first part, of the two collectors, the at least one emitter, and the plurality of bases respectively, that is close to the substrate, and exposes a second part, of the two collectors, the at least one emitter, and the plurality of bases respectively, that is away from the substrate.

13. The FinBJT according to claim 12, wherein the FinBJT further comprises a plurality of first interconnection structures, at least one third interconnection structure, and a plurality of fourth interconnection structures that are disposed on the shallow groove isolation structure;
extension directions of the plurality of first interconnection structures, the at least one third interconnection structure, and the plurality of fourth interconnection structures intersect with the extension direction of the collector;
a top surface and two opposite side surfaces of the second part of each collector are in contact with at least one first interconnection structure;
a top surface and two opposite side surfaces of the second part of each emitter are in contact with the at least one third interconnection structure; and
a top surface and two opposite side surfaces of the second part of each base are in contact with at least one fourth interconnection structure.

14. The FinBJT according to claim 13, wherein a top surface and two opposite side surfaces of the second part of each base are in contact with one fourth interconnection structure.

15. The FinBJT according to any one of claims 11 to 14, wherein the FinBJT further comprises:
a collector line, disposed on the two collectors, and connected to and in contact with the two collectors;
an emitter line, disposed on the at least one emitter, and connected to and in contact with the at least one emitter; and
a base line, disposed on the plurality of bases, and connected to and in contact with the plurality of bases.

16. A preparation method of a fin-bipolar junction transistor FinBJT, comprising:
forming a mask plate on a basement; and
etching, a part, of the basement, that is not covered by the mask plate, to form a substrate and two collectors, at least one emitter, and a plurality of bases that are located on the substrate, wherein
the at least one emitter and the plurality of bases are all located between the two collectors and arranged along an extension direction of the collector; and along the extension direction of the collector, the emitter is disposed between adjacent bases, and the base is located on an outermost side.

17. The preparation method of the FinBJT according to claim 16, wherein the preparation method further comprises:
forming a shallow groove isolation structure on the substrate, wherein
the shallow groove isolation structure wraps a first part, of the two collectors, the at least one emitter, and the plurality of bases respectively, that is close to the substrate, and exposes a second part, of the two collectors, the at least one emitter, and the plurality of bases respectively, that is away from the substrate.

18. The preparation method of the FinBJT according to claim 17, wherein the preparation method further comprises:
forming a plurality of first interconnection structures, at least one third interconnection structure, and a plurality of fourth interconnection structures on the shallow groove isolation structure, wherein
extension directions of the plurality of first interconnection structures, the at least one third interconnection structure, and the plurality of fourth interconnection structures intersect with the extension direction of the collector; a top surface and two opposite side surfaces of the second part of each collector are in contact with at least one first interconnection structure; a top surface and two opposite side surfaces of the second part of each emitter are in contact with the at least one third interconnection structure; and a top surface and two opposite side surfaces of the second part of each base are in contact with at least one fourth interconnection structure.

19. The preparation method of the FinBJT according to claim 18, wherein after the plurality of first interconnection structures, the at least one third interconnection structure, and the plurality of fourth interconnection structures are formed, the preparation method further comprises:
forming a collector line, an emitter line, and a base line, wherein
the collector line is connected to and in contact with the two collectors, the emitter line is connected to and in contact with the at least one emitter, and the base line is connected to and in contact with the plurality of bases.

20. A fin-bipolar junction transistor FinBJT, comprising:
a substrate;
two collectors, disposed on the substrate, wherein the two collectors are disposed in parallel;
a plurality of emitters, disposed on the substrate; and
at least one base, disposed on the substrate, wherein
the plurality of emitters and the at least one base are all located between the two collectors and arranged along an extension direction of the collector; and along the extension direction of the collector, the base is disposed between adjacent emitters, and the emitter is located on an outermost side.

21. The FinBJT according to claim 20, wherein the FinBJT further comprises a shallow groove isolation structure, and the shallow groove isolation structure is disposed on the substrate; and
the shallow groove isolation structure wraps a first part, of the two collectors, the plurality of emitters, and the at least one base respectively, that is close to the substrate, and exposes a second part, of the two collectors, the plurality of emitters, and the at least one base respectively, that is away from the substrate.

22. The FinBJT according to claim 21, wherein the FinBJT further comprises a plurality of first interconnection structures, a plurality of third interconnection structures, and at least one fourth interconnection structure that are disposed on the shallow groove isolation structure;
extension directions of the plurality of first interconnection structures, the plurality of third interconnection structures, and the at least one fourth interconnection structure intersect with the extension direction of the collector;
a top surface and two opposite side surfaces of the second part of each collector are in contact with at least one first interconnection structure; and
a top surface and two opposite side surfaces of the second part of each emitter are in contact with at least one third interconnection structure; and
a top surface and two opposite side surfaces of the second part of each base are in contact with the at least one fourth interconnection structure.

23. The FinBJT according to claim 22, wherein a top surface and two opposite side surfaces of the second part of each base are in contact with one fourth interconnection structure.

24. The FinBJT according to any one of claims 20 to 23, wherein the FinBJT further comprises:
a collector line, disposed on the two collectors, and connected to and in contact with the two collectors;
an emitter line, disposed on the plurality of emitters, and connected to and in contact with the plurality of emitters; and
a base line, disposed on the at least one base, and connected to and in contact with the at least one base.

25. A preparation method of a fin-bipolar junction transistor FinBJT, comprising:
forming a mask plate on a basement; and
etching, a part, of the basement, that is not covered by the mask plate, to form a substrate and two collectors, a plurality of emitters, and at least one base that are located on the substrate, wherein
the plurality of emitters and the at least one base are all located between the two collectors and arranged along an extension direction of the collector; and along the extension direction of the collector, the base is disposed between adjacent emitters, and the emitter is located on an outermost side.

26. The preparation method of the FinBJT according to claim 25, wherein the preparation method further comprises:
forming a shallow groove isolation structure on the substrate, wherein
the shallow groove isolation structure wraps a first part, of the two collectors, the plurality of emitters, and the at least one base respectively, that is close to the substrate, and exposes a second part, of the two collectors, the plurality of emitters, and the at least one base respectively, that is away from the substrate.

27. The preparation method of the FinBJT according to claim 26, wherein the preparation method further comprises:
forming a plurality of first interconnection structures, a plurality of third interconnection structures, and at least one fourth interconnection structure on the shallow groove isolation structure, wherein
extension directions of the plurality of first interconnection structures, the plurality of third interconnection structures, and the at least one fourth interconnection structure intersect with the extension direction of the collector; a top surface and two opposite side surfaces of the second part of each collector are in contact with at least one first interconnection structure; a top surface and two opposite side surfaces of the second part of each emitter are in contact with at least one third interconnection structure; and a top surface and two opposite side surfaces of the second part of each base are in contact with the at least one fourth interconnection structure.

28. The preparation method of the FinBJT according to claim 27, wherein after the plurality of first interconnection structures, the plurality of third interconnection structures, and the at least one fourth interconnection structure are formed, the preparation method further comprises:
forming a collector line, an emitter line, and a base line, wherein
the collector line is connected to and in contact with the two collectors, the emitter line is connected to and in contact with the plurality of emitters, and the base line is connected to and in contact with the at least one base.

29. An electronic device, comprising an integrated circuit and a printed circuit board, wherein the integrated circuit is electrically connected to the printed circuit board; and
the integrated circuit comprises the fin-bipolar junction transistor FinBJT according to any one of claims 1 to 6, any one of claims 11 to 15, or any one of claims 20 to 24.

30. The electronic device according to claim 29, wherein the integrated circuit further comprises a fin field-effect transistor FinFET, and a gate in the FinFET and a first interconnection structure in the FinBJT are disposed at a same layer.
